# EUROPEAN PATENT APPLICATION

(11) **EP 1 772 536 A1**
(43) Date of publication of application: **11.04.2007**
(21) Application number: 06021548.0
(22) Date of filing: 11.09.2002
(51) Int. Cl.: C25F 1/00, C25F 7/00, C25F 3/00, H01L 21/3213

(54) **Electrolytic processing apparatus and method**

(30) Priority: 11.09.2001 JP 2001275113; 29.11.2001 JP 2001365148; 30.05.2002 JP 2002158162; 31.07.2002 JP 2002223313; 14.08.2002 JP 2002236295
(62) Divisional of application: 02772846.8
(71) Applicant: EBARA CORPORATION, Ohta-ku, Tokyo 144-8510 (JP)
(72) Inventor: Kobata, Itsuki, Tokyo 144-8510 (JP); Shirakashi, Mitsuhiko, Tokyo 144-8510 (JP); Kumekawa, Masayuki, Tokyo 144-8510 (JP); Saito, Takayuki, Fujisawa-shi Kanagawa 251-8502 (JP); Toma, Yasushi, Fujisawa-shi Kanagawa 251-8502 (JP); Suzuki, Tsukuru, Fujisawa-shi Kanagawa 251-8502 (JP); Yamada, Kaoru, Fujisawa-shi Kanagawa 251-8502 (JP); Makita, Yuji, Fujisawa-shi Kanagawa 251-8502 (JP); Yasuda, Hozumi, Tokyo 144-8510 (JP); Noji, Ikutaro, Tokyo 144-8510 (JP); Fujiwara, Kunio, Fujisawa-shi Kanagawa 251-8502 (JP); Nabeya, Osamu, Tokyo 144-8510 (JP)
(74) Representative: Wagner, Karl H.

(57) **Abstract**

There is provided an electrolytic processing apparatus and method which, while omitting a CMP treatment entirely or reducing a load upon a CMP treatment to the least possible extent, can process a conductive material formed in the surface of a substrate to flatten the material, or can remove (clean) extraneous matter adhering to the surface of a workpiece such as a substrate. The electrolytic processing apparatus includes: a pair of electrodes disposed at a given distance; an ion exchange disposed between the pair of electrodes; and a liquid supply section for supplying a liquid between the pair of electrodes. The electrolytic processing method includes: providing an electrode section having a pair of electrodes disposed at a given distance with an ion exchanger being interposed; and bringing the electrode into contact with or close to a workpiece while supplying a fluid to the ion exchanger, thereby processing the surface of the workpiece.

## Description

### Technical Field

This invention relates to an electrolytic processing apparatus and method, and more particularly to an electrolytic processing apparatus and method useful for processing a conductive material present in the surface of a substrate, especially a semiconductor wafer, or for removing impurities adhering to the surface of a substrate.

### Background Art

In recent years, instead of using aluminum or aluminum alloys as a material for forming interconnection circuits on a substrate such as a semiconductor wafer, there is an eminent movement towards using copper (Cu) which has a low electric resistance and high electromigration resistance. Copper interconnects are generally formed by filling copper into fine recesses formed in the surface of a substrate. There are known various techniques for forming such copper interconnects, including CVD, sputtering, and plating. According to any such technique, a copper film is formed in the substantially entire surface of a substrate, followed by removal of unnecessary copper by chemical mechanical polishing (CMP).

FIGS. 1A through 1C illustrate, in sequence of process steps, an example of forming such a substrate W having copper interconnects. As shown in FIG. 1A, an insulating film 2, such as a silicon oxide film of SiO₂ or a film of low-k material, is deposited on a conductive layer 1a in which electronic devices are formed, which is formed on a semiconductor base 1. A contact hole 3 and a trench 4 for interconnects are formed in the insulating film 2 by the lithography and etching technique. Thereafter, a barrier layer 5 of TaN or the like is formed on the entire surface, and a seed layer 7 as an electric supply layer for electroplating is formed on the barrier layer 5.

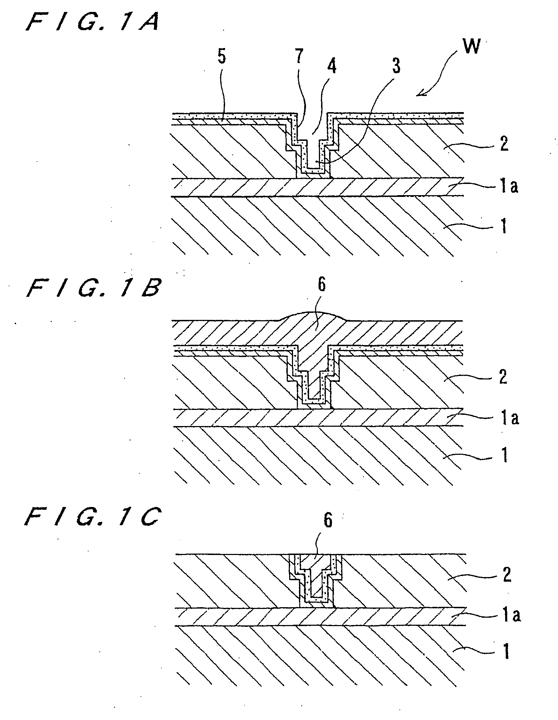

Then, as shown in FIG. 1B, copper plating is performed onto the surface of the substrate W to fill the contact hole 3 and the trench 4 with copper and, at the same time, deposit a copper film 6 on the insulating film 2. Thereafter, the copper film 6 and the barrier layer 5 on the insulating film 2 are removed by chemical mechanical polishing (CMP) so as to make the surface of the copper film 6 filled in the contact hole 3 and the trench 4 for interconnects and the surface of the insulating film 2 lie substantially on the same plane. An interconnection composed of the copper film 6 as shown in FIG. 1C is thus formed.

Components in various types of equipments have recently become finer and have required higher accuracy. As sub-micro manufacturing technology has commonly been used, the properties of materials are largely influenced by the processing method. Under these circumstances, in such a conventional machining method that a desired portion in a workpiece is physically destroyed and removed from the surface thereof by a tool, a large number of defects may be produced to deteriorate the properties of the workpiece. Therefore, it becomes important to perform processing without deteriorating the properties of the materials.

Some processing methods, such as chemical polishing, electrolytic processing, and electrolytic polishing, have been developed in order to solve this problem. In contrast with the conventional physical processing, these methods perform removal processing or the like through chemical dissolution reaction. Therefore, these methods do not suffer from defects, such as formation of an altered layer and dislocation, due to plastic deformation, so that processing can be performed without deteriorating the properties of the materials.

Chemical mechanical polishing (CMP), for example, generally necessitates a complicated operation and control, and needs a considerably long processing time. In addition, a sufficient cleaning of a substrate must be conducted after the polishing treatment. This also imposes a considerable load on the slurry or cleaning liquid waste disposal. Accordingly, there is a strong demand for omitting CMP entirely or reducing a load upon CMP. Also in this connection, it is to be pointed out that though a low-k material, which has a low dielectric constant, is expected to be predominantly used in the future as a material for the insulating film of a semiconductor substrate, the low-k material has a low mechanical strength and therefore is hard to endure the stress applied during CMP processing. Thus, also from this standpoint, there is a demand for a technique that enables the flattering of a substrate without giving any stress thereto.

Further, a method has been reported which performs CMP processing simultaneously with plating, viz. chemical mechanical electrolytic polishing. According to this method, the mechanical processing is carried out to the growing surface of a plating film, causing the problem of denaturing of the resulting film.

In the case of the above-mentioned electrolytic processing or electrolytic polishing, the process proceeds through an electrochemical interaction between a workpiece and an electrolytic solution (aqueous solution of NaCl , NaNO₃, HF, HCl, HNO₃, NaOH, etc.). Since an electrolytic solution containing such an electrolyte must be used, contamination of a workpiece with the electrolyte cannot be avoided.

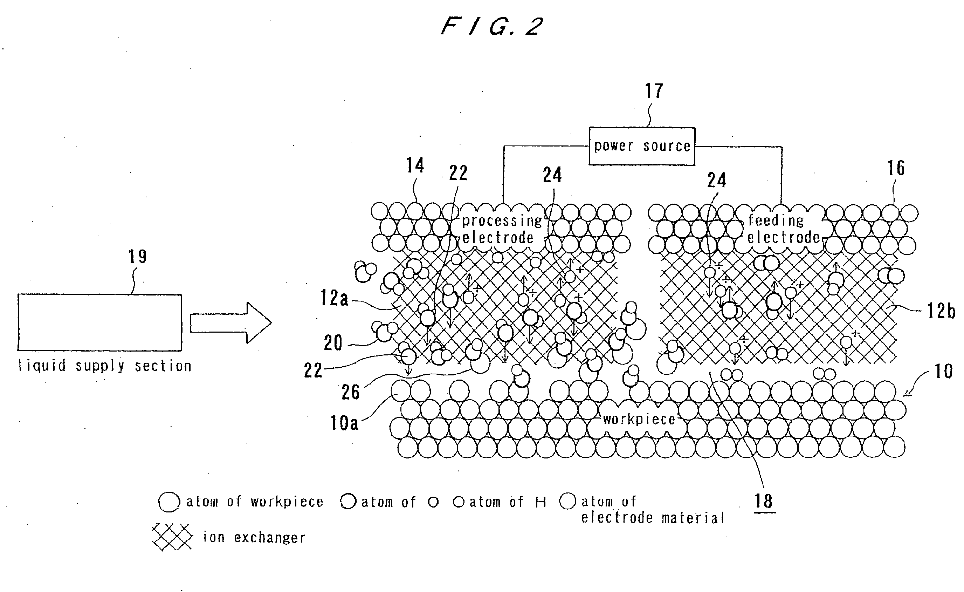

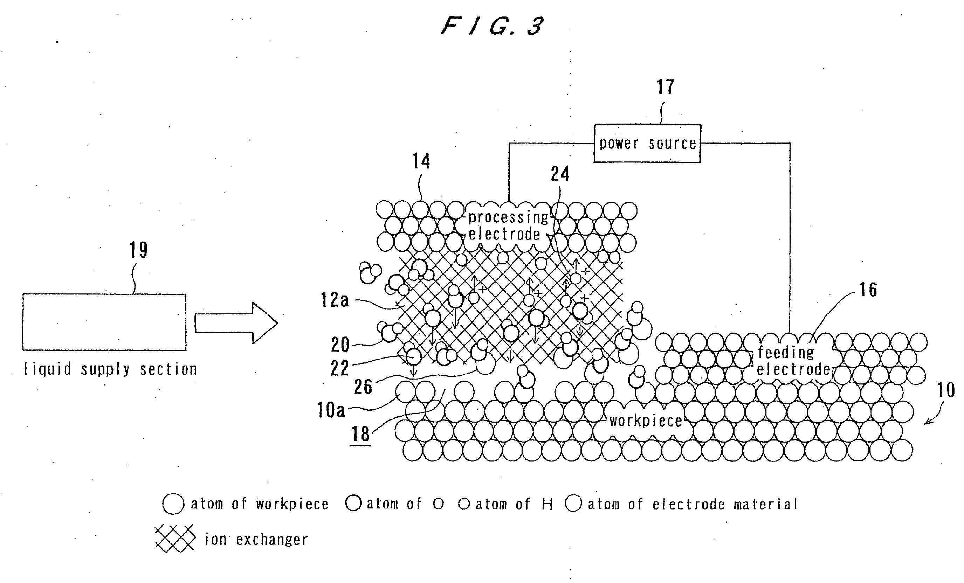

A processing method provided with an ion exchanger has been developed as electrolytic processing. FIGS. 2 and 3 illustrate the principle of this electrolytic processing. FIG. 2 shows the ionic state when an ion exchanger 12a mounted on a processing electrode 14 and an ion exchanger 12b mounted on a feeding electrode 16 are brought into contact with or close to a surface of a workpiece 10, while a voltage is applied via a power source 17 between the processing electrode 14 and the feeding electrode 16, and a liquid 18, e.g. ultrapure water, is supplied from a liquid supply section 19 between the processing electrode 14, the feeding electrode 16 and the workpiece 10. FIG. 3 shows the ionic state when the ion exchanger 12a mounted on the processing electrode 14 is brought into contact with or close to the surface of the workpiece 10 and the feeding electrode 16 is directly contacted with the workpiece 10, while a voltage is applied via the power source 17 between the processing electrode 14 and the feeding electrode 16, and the liquid 18, such as ultrapure water, is supplied from the liquid supply section 19 between the processing electrode 14 and the workpiece 10.

When a liquid like ultrapure water that in itself has a large resistivity is used, it is preferred to bring the ion exchanger 12a into contact with the surface of the workpiece 10. This can lower the electric resistance, lower the requisite voltage and reduce the power consumption. The "contact" in the present electrolytic processing does not imply "press" for giving a physical energy (stress) to a workpiece as in CMP.

Water molecules 20 in the liquid 18 such as ultrapure water are dissociated efficiently by using the ion exchangers 12a, 12b into hydroxide ions 22 and hydrogen ions 24. The hydroxide ions 22 thus produced, for example, are carried, by the electric field between the workpiece 10 and the processing electrode 14 and by the flow of the liquid 18, to the surface of the workpiece 10 opposite to the processing electrode 14 whereby the density of the hydroxide ions 22 in the vicinity of the workpiece 10 is enhanced, and the hydroxide ions 22 are reacted with the atoms 10a of the workpiece 10. The reaction product 26 produced by this reaction is dissolved in the liquid 18, and removed from the workpiece 10 by the flow of the liquid 18 along the surface of the workpiece 10. Removal processing of the surface of the workpiece 10 is thus effected.

As will be appreciated from the above, the removal processing according to this processing method is effected purely by the electrochemical interaction between the reactant ions and the workpiece. This electrolytic processing thus clearly differs in the processing principle from CMP according to which processing is effected by the combination of the physical interaction between an abrasive and a workpiece, and the chemical interaction between a chemical species in a polishing liquid and the workpiece.

According to the above-described method, the portion of the workpiece 10 facing the processing electrode 14 is processed. Therefore, by moving the processing electrode 14, the workpiece 10 can be processed into a desired surface configuration.

As described above, the removal processing of the electrolytic processing is effected solely by the dissolution reaction due to the electrochemical interaction, and is clearly distinct in the processing principle from CMP in which processing is effected by the combination of the physical interaction between an abrasive and a workpiece, and the chemical interaction between a chemical species in a polishing liquid and the workpiece. Accordingly, the electrolytic processing can conduct removal processing of the surface of a workpiece without impairing the properties of the material of the workpiece. Even when the material of a workpiece is of a low mechanical strength, such as the above-described low-k material, removal processing of the surface of the workpiece can be effected without any physical damage to the workpiece.

In carrying out electrolytic processing of a workpiece by using an ion exchanger, which is disposed in at least one of the space between the processing electrode and the workpiece and the space between the feeding electrode and the workpiece, as described above, the physical properties and the form of the ion exchanger greatly affects the processing of the surface of the workpiece. For example, copper ions, with which the ion exchanger can be saturated upon processing, may adversely affect the processing efficiency. Further, when an ion exchanger having a low water permeability is used, supply of a liquid to the surface of the workpiece becomes difficult, whereby removal of the processing product produced on the surface of the workpiece becomes difficult. Moreover, the hardness and the surface smoothness of the ion exchanger may considerably affect the surface of the workpiece.

The electrolytic processing (electrochemical processing) proceeds through electrochemical interaction between the reactant ions and a workpiece, and the processing rates at various points in the surface of the workpiece basically depend, if the physical properties of the workpiece is constant at each point of the surface of the workpiece, on the current density and the frequency of presence of the processing electrode. In practical processing, the processing rates at various points in the surface of a workpiece are likely to be uneven due to unevenness of the electrolytic reaction in the surface of the workpiece. As a method for overcoming the unevenness of processing rate, it may be considered to (1) equalize the electrolytic reaction, or (2) allow a plurality of electrodes to pass each of the various points in the surface of a workpiece so as to equalize the processing rates at the various points.

With respect to the method (1), however, it becomes necessary to remove the processing product and gas bubbles generated upon the electrolytic reaction and to suppress the concentration of electric field on the end of an electrode. With respect to the method (2), though the equalization of processing rate may be attained by allowing the presence of a large number of electrodes, the electrode should necessary be fractionated, making the electrode complicated.

### Disclosure of Invention

The present invention has been made in view of the above situation in the related art. It is therefore a first object of the present invention to provide an electrolytic processing apparatus and method which, while omitting a CMP treatment entirely or reducing a load upon a CMP treatment to the least possible extent, can process a conductive material formed in the surface of a substrate to flatten the material, or can remove (clean) extraneous matter adhering to the surface of a workpiece such as a substrate.

It is a second object of the present invention to provide an electrolytic processing apparatus and method which, when processing e.g. a conductive material in the surface of a workpiece, can efficiently perform the processing and provide the processed workpiece with a high surface flatness.

It is a third object of the present invention to provide an electrolytic processing apparatus and method which, in electrolytic processing that takes the place of the above-described conventional processing, can effectively remove gas bubbles etc., present between a processing surface and a to-be-processed surface, which would worsen the evenness in the processing amount of the to-be-plated surface and could be a cause of roughness of the processed surface.

In order to achieve the above obj ect, the present invention provides an electrolytic processing apparatus, comprising: a pair of electrodes disposed at a given distance; an ion exchanger disposed between the pair of electrodes; and a liquid supply section for supplying a liquid to the ion exchanger.

According to the electrolytic processing apparatus, processing of a workpiece proceeds as follows:

Water molecules in the liquid, e.g. ultrapure water, are dissociated through the catalytic reaction in an ion exchanger into OH⁻ ions and H⁺ ions. By the electric field and the flow of ultrapure water, the OH⁻ ions, for example, are moved to the anode. The OH⁻ ions transfer the electric charge and become OH radicals. The OH radicals thus generated in the vicinity of the anode are supplied to a to-be-processed material, and reaction between the OH radicals and the atoms of the material takes place. The reaction product dissolves in ultrapure water, and is removed from the workpiece. Removal processing of the workpiece (removal of the to-be-processed material) is thus effected.

It is preferable to cover the exposed surface of the electrode with a water-permeable member. This prevents the electrode from directly contacting a to-be-processed material, thereby prolonging the life of the electrode. It is possible to separately supply a slurry during the electrolytic processing so as to perform a CMP processing simultaneously.

The ion exchanger may be a laminate of a plurality of ion-exchange materials. By making the ion exchanger a multi-layer structure consisting of laminated layers of ion-exchange materials, such as ion-exchange fibers and an ion-exchange membrane, it is possible to increase the total ion exchange capacity whereby formation of an oxide, for example in removal (polishing) processing of copper, can be restrained to thereby avoid the oxide adversely affecting the processing rate. The ion exchanger may have water-absorbing properties. This allows a liquid such as ultrapure water to flow within the ion exchanger.

The ion exchanger may have one or both of an anion-exchange ability and a cation-exchange ability. An ion exchanger having an anion-exchange ability and an ion exchanger having a cation-exchange ability can be used selectively according to a substrate. The use of an ion-exchanger having both of anion-exchange and cation-exchange abilities can broaden the range of processible materials and, in addition, can prevent the formation of impurities due to the polarity.

The liquid may be pure water, a liquid having an electric conductivity (referring herein to that at 25 °C, 1 atm) of not more than 500 µS/cm; or an electrolytic solution.

Pure water may be a water having an electric conductivity of not more than 10 µS/cm. The use of pure water in electrolytic processing enables a clean processing without leaving impurities on the processed surface of a workpiece, whereby a cleaning step after the electrolytic processing can be simplified. Specifically, one or two-stages of cleaning may suffice after the electrolytic processing.

It is also possible to use a liquid obtained by adding an additive, such as a surfactant, to pure water or ultrapure water, and having an electric conductivity of not more than 500 µS/cm, preferably not more than 50 µS/cm, more preferably not more than 0.1 µS/cm (resistivity of not less than 10 MΩ · cm). Such a liquid can form a layer, which functions to inhibit ion migration evenly, at the interface between a workpiece (e.g. substrate) and an ion exchanger, thereby moderating concentration of ion exchange (metal dissolution) to enhance the flatness of the processed surface.

The additive plays a role to prevent local concentration of ions (e.g. hydroxide ions (OH⁻)). It is noted in this regard that "an equal processing (removal) rate at various points over the entire processing surface" is an important factor for providing a flat processed surface. When a single electrochemical removal reaction is in progress, a local difference in the processing removal rate may be produced by a local concentration of reactant ions. The local concentration of reactant ions may be caused mainly by a deviation in the electric field intensity between the processing electrode and the feeding electrode, and a deviation in the distribution of reactant ions in the vicinity of the surface of a workpiece. The local concentration of reactant ions can be prevented by allowing the additive, which plays a role to prevent local concentration of ions (e.g. hydroxide ions), to exist between a workpiece and an ion exchanger.

An aqueous solution of a neutral salt such as NaCl or Na₂SO₄, an acid such as HCl or H₂SO₄, or an alkali such as ammonia may be used as the electrolytic solution, and may be properly selected according to the properties of a workpiece. When using electrolytic solution, it is better to use the low concentration electrolytic solution which electric conductivity is not more than 500 µS/cm, to avoid much contamination.

Ultrapure water is preferably used as the liquid. By "ultrapure water" is herein meant a water having an electric conductivity of not more than 0.1 µS/cm. The use of ultrapure water enables a cleaner processing without leaving impurities on the processed surface of a workpiece.

The present invention also provides an electrolytic processing method, comprising: providing an electrode section having a pair of electrodes disposed at a given distance with an ion exchanger being interposed; and bringing the electrode section into contact with or close to a workpiece while supplying a fluid to the ion exchanger, thereby processing the surface of the workpiece.

The present invention also provides an electrolytic processing apparatus, comprising: a processing electrode which can come close to or into contact with a workpiece; a feeding electrode for feeding electricity to the workpiece; a laminate of a multi-layer structure disposed in at least one of the space between the workpiece and the processing electrode and the space between the workpiece and the feeding electrode; a fluid supply section for supplying a fluid to the space between the workpiece and at least one of the processing and feeding electrodes in which the laminate is present; and a power source for applying a voltage between the processing electrode and the feeding electrode.

By thus disposing the laminate of a multi-layer structure having an enhanced accumulation capacity (ion-exchanger capacity in case of an ion exchanger) in at least one of a workpiece and the processing electrode and the space between a workpiece and the feeding electrode, the reaction products (oxides and ions) of the electrolytic reaction can be prevented from accumulating in the laminate in an amount exceeding the accumulation capacity of the laminate. In this regard, if the reaction products are accumulated in the laminate in an amount exceeding the accumulation capacity, the accumulated products may change their forms, and such transformed products can adversely affect the processing rate and its distribution.

The electrolytic processing apparatus may further comprise a regeneration section for regenerating the laminate. This makes it possible to regenerate the laminate during processing or in the interval of processings so as to remove the reaction products from the laminate, thereby preventing the reaction products accumulated in the laminate adversely affecting the processing rate and its distribution.

The laminate preferably includes in at least one layer an ion exchanger having at least one of a cation-exchange group and an anion-exchange group. The kind of a to-be-processed material that can be processed or removed and the processing efficiency can vary depending on the type of the functional group of the' ion exchanger. It is therefore desirable to vary the exchange group of the ion exchanger depending on the to-be-processed material. This can broaden the range of processible materials.

The laminate preferably includes in at least one layer a water-permeable material. The water permeability of the laminate is related to the removal efficiency of the reaction products of the electrolytic reaction and therefore to the stability of the electrolytic reaction. The better the water permeability of the laminate is, the higher is the removal efficiency. Accordingly, the use of a highly water-permeable laminate enables a stable electrolytic reaction.

The laminate preferably has in at least one layer a material having a high hardness. The hardness of the laminate is related to the surface flatness of the processed workpiece. The higher the hardness of the laminate is, the higher is the flatness of the processed surface. Accordingly, the use of a laminate having a high hardness can provide the processed workpiece with a higher surface flatness. It is desirable that the laminate have such a hard material at least in the outermost layer that contacts the workpiece. By thus making harder the surface of the laminate to be contacted with the workpiece, the surface flatness of the processed workpiece can be effectively enhanced.

Further, it is preferable that the laminate have a material having a surface smoothness at least in the outermost layer that contacts the workpiece. The surface smoothness of the laminate is related to the surface flatness of the processed workpiece. The better the surface smoothness of the laminate is, the higher is the surface flatness of the processed workpiece. Accordingly, by using a material having a good surface smoothness in the outermost layer of the laminate that contacts the workpiece, the flatness of the processed surface can be enhanced.

Examples of the materials for the laminate may include a woven cloth, a net, an ion-exchange membrane, a polishing pad for chemical mechanical polishing, etc.

The present invention also provides an electrolytic processing method, comprising: bringing a processing electrode into contact with or close to a workpiece while feeding electricity from a feeding electrode to the workpiece; disposing a laminate of a multi-layer structure in at least one of the space between the workpiece and the processing electrode and the space between the workpiece and the feeding electrode; supplying a fluid to the space between the workpiece and at least one of the processing and feeding electrodes in which the laminate is present; and applying a voltage between the processing electrode and the feeding electrode, thereby processing the surface of the workpiece.

The present invention also provides an electrolytic processing apparatus, comprising: a processing electrode which can come close to or into contact with a workpiece; a feeding electrode for feeding electricity to the workpiece; an ion exchanger of a single- or multi-layer structure disposed between the workpiece and the processing electrode or between the workpiece and the feeding electrode, having in the surface on the workpiece side a plurality of divided surfaces that face or contact the workpiece; a fluid supply section for feeding a fluid to the space between the workpiece and at least one of the processing and feeding electrodes in which the ion exchanger is present; and a power source for applying a voltage between the processing electrode and the feeding electrode.

This apparatus allows a plurality of divided surfaces of the ion exchanger to pass an every point in the surface of a workpiece. Thus, without fragmentation of the electrode itself, the same effect as the fragmentation of the electrode, i.e. equalization (evenness) of the processing rate, can be produced.

The divided surfaces of the ion exchanger may be the top surfaces of projection portions in depressions (hollows) /projections (protrusions) formed in the surface on the workpiece side of the ion exchanger. The plurality of divided surfaces of the ion exchanger can thus be provided in such a simple manner of providing depressions (hollows)/projections (protrusions) in the surface of the ion exchanger.

The projections may be formed by die molding. This makes it possible to mold e.g. the outermost layer of an ion exchanger of a multi-layer laminate structure into a desired configuration and provide a number of divided surfaces in the surface of the ion exchanger.

The depressions may be formed by grooving process in the surface of the ion exchanger. By grooving the surface of an ion exchanger e.g. of a single layer structure to form grooves, a number of divided surfaces can be provided in the surface of the ion exchanger.

The apparatus preferably has holes for supplying a fluid to or sucking the fluid from the depressions. By providing depressions in a lattice form or in a continuous form, a liquid can be supplied through the holes and spread over the entire surfaces of the ion exchanger and the workpiece.

The divided surfaces may each have a desired form, for example a circular or rectangular form, and may be distributed uniformly over the surface of the ion exchanger, or randomly in dots, or in a regular manner.

The present invention also provides an electrolytic processing method, comprising: bringing a processing electrode into contact with or close to a workpiece while feeding electricity from a feeding electrode to the substrate; disposing an ion exchanger of a single- or multi-layer structure between the workpiece and the processing electrode or between the workpiece and the feeding electrode, the ion exchanger having in the surface on the workpiece side a plurality of divided surfaces that face or contact the workpiece; supplying a fluid to the space between the workpiece and at least one of the processing and feeding electrodes in which the ion exchanger is present; and applying a voltage between the processing electrode and the feeding electrode, thereby processing the surface of the workpiece.

The present invention provides still another electrolytic processing apparatus, comprising: a processing electrode; a feeding electrode for supplying electricity to a workpiece; a workpiece holder for holding the workpiece and bringing the workpiece into contact with or close to the processing electrode; a power source for applying a voltage between the processing electrode and the feeding electrode; and a moving mechanism for moving the workpiece held by the workpiece holder and the processing electrode relatively to each other; wherein at least one of the processing electrode and the feeding electrode has at least one liquid suction hole defined therein for drawing a liquid present between the workpiece and at least one of the processing electrode and the feeding electrode.

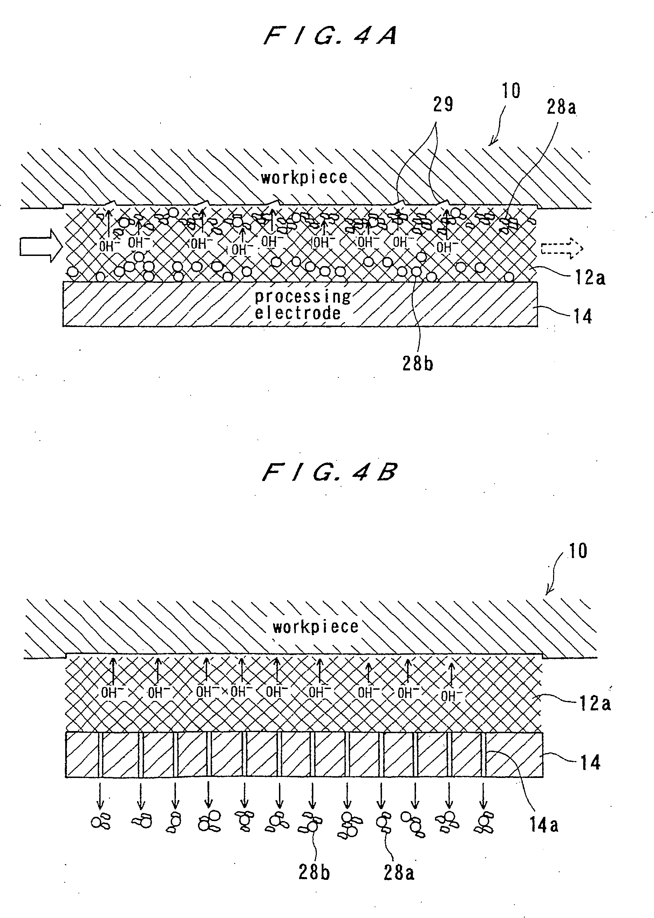

As described above with reference to FIGS. 2 and 3, in the electrolytic processing apparatus according to the present invention, reactant ions move towards the surface of the workpiece 10 due to the electric field produced between the processing and feeding electrodes 14, 16 and the workpiece 10. Therefore, if inhibitors which inhibit the movement of the ions are produced, then these inhibitors adversely affect on the constancy and uniformity of the processed surface of the workpiece 10. As shown in FIG. 4A, the inhibitors include process products 28a produced on the surface of the workpiece 10 in the process by electrochemical reactions of the workpiece 10 and the ions, and bubbles 28b produced by side reactions on the surfaces of the workpiece 10 and the electrodes. If these inhibitors are present between the workpiece 10 and the processing electrode 14 (or the feeding electrode), then they prevent the movement of the ions to inhibit the constancy and uniformity of the processing rate on the surface of the workpiece 10. Particularly, the bubbles 28b present between the processing electrode 14 and the workpiece 10 may cause pits or small holes 29 (see FIG. 4A) to be formed on the surface of the workpiece 10. Therefore, in order to process the surface of the workpiece uniformly and equally, it is required to remove inhibitors which inhibit the movement of the ions immediately after the inhibitors are produced.

However, the distance between the workpiece 10 and the processing electrode 14 is in the range from 0.1 mm to several millimeters, and the ion exchangers 12a, 12b have a liquid resistance. Therefore, when the liquid is supplied only from the external liquid supply section 19, it is difficult to immediately remove the inhibitors from the surface of the workpiece 10. Further, when the workpiece 10 has a larger area to be processed, it is more difficult to remove the inhibitors from the surface of the workpiece 10. In the electrolytic processing apparatus according to the present invention, as shown in FIG. 4B, liquid suction holes 14a are formed for drawing a liquid present between the workpiece 10 and the processing electrode 14 (or the feeding electrode). The liquid present between the workpiece 10 and the ion exchangers 12a, 12b is drawn through the liquid suction holes 14a together with the inhibitors of the process products 28a and the bubbles 28b. Thus, according to the present invention, the inhibitors 28a, 28b which inhibit the movement of the ions are immediately removed and discharged from the surface of the workpiece 10. Therefore, the surface of the workpiece 10 can uniformly and equally be processed without influence of the inhibitors. In this case, it is more effective to draw the liquid from the surface facing the workpiece 10.

At least one of the processing electrode and the feeding electrode preferably has at least one liquid supply hole defined therein for supplying the liquid into between the workpiece and at least one of the processing electrode and the feeding electrode.

The liquid suction hole preferably is defined in one of the processing electrode and the feeding electrode, and the liquid supply hole is defined in the other of the processing electrode and the feeding electrode.

The electrode having the liquid suction hole preferably comprises a mesh electrode. In this case, since a large number of liquid suction holes are formed by a mesh of the mesh electrode, the efficiency of drawing the liquid can be enhanced.

According to a preferred aspect of the present invention, the electrolytic processing apparatus further comprises an ion exchanger disposed in at least one of spaces between the workpiece and the processing electrode and between the workpiece and the feeding electrode.

The liquid may be supplied from the exterior of the processing electrode and the feeding electrode into between the workpiece and at least one of the processing electrode and the feeding electrode.

The liquid may comprise at least one of pure water, ultrapure water, and liquid having an electric conductivity of not more than 500 µS/cm.

Each of the processing electrode and the feeding electrode includes not only a single electrode, but also an electrode assembly having a plurality of small electrodes. When the processing electrode or the feeding electrode comprises an electrode assembly having a plurality of small electrodes, the liquid suction holes and/or the liquid supply holes may be formed between the small electrodes.

The present invention provides still another electrolytic processing method, comprising: disposing a processing electrode and a feeding electrode; applying a voltage between the processing electrode and the feeding electrode; bringing a workpiece into contact with or close to the processing electrode; drawing a liquid present between the workpiece and at least one of the processing electrode and the feeding electrode, through at least one liquid suction hole defined in at least one of the processing electrode and the feeding electrode; and processing a surface of the workpiece while the workpiece and the processing electrode are being moved relatively to each other

The present invention provides still another electrolytic processing apparatus, comprising: a processing electrode; a feeding electrode for supplying electricity to a workpiece; a workpiece holder for holding the workpiece and bringing the workpiece into contact with or close to the processing electrode; a power source for applying a voltage between the processing electrode and the feeding electrode; a moving mechanism for moving the workpiece held by the workpiece holder and the processing electrode relatively to each other; and a partition wall for isolating a liquid flowing on at least one of the processing electrode and the feeding electrode and a liquid flowing on the workpiece from each other.

As described above with reference to FIG. 4A, in order to process the surface of the workpiece uniformly, it is required to remove inhibitors which inhibit the movement of the ions immediately after the inhibitors are produced.

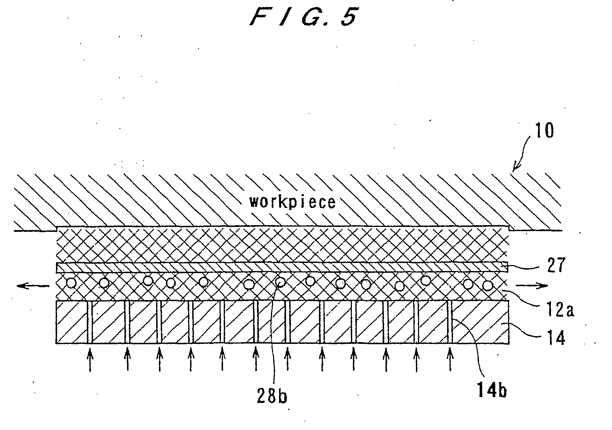

As shown in FIG. 5, the electrolytic processing apparatus according to the present invention comprises a partition wall 27 for isolating the liquid flowing on the processing electrode 14 (or the feeding electrode) and the liquid flowing on the workpiece 10 from each other. Therefore, bubbles 28b produced near the processing electrode 14 are blocked by the partition wall 27 and do not reach the surface of the workpiece 10. Specifically, the partition wall 27 isolates the liquid flowing on the processing electrode 14 (or the feeding electrode), on which gases (bubbles) are produced, from the liquid flowing on the workpiece, so that the liquid flowing on the processing electrode can be controlled independently of the liquid flowing on the workpiece. Accordingly, it is possible to prevent pits from being produced on the surface of the workpiece 10. From this point of view, the partition wall 27 should preferably have a gas permeability smaller than the ion exchanger 12a or have no gas permeability. Such a partition wall 27 can block bubbles produced or developed on the electrode.

As shown in FIG. 5, when a liquid is supplied onto the processing electrode through liquid supply holes 14b defined in the processing electrode 14 (or the feeding electrode), a flow of the liquid which is isolated from the liquid flowing on the workpiece 10 by the partition wall 27 can be formed on the processing electrode 14. Therefore, bubbles 28b produced on the processing electrode 14 can effectively be removed by the liquid flowing on the electrode.

Further, when a liquid suction hole is formed in at least one of the processing electrode and the feeding electrode for drawing a liquid present on at least one of the processing electrode and the feeding electrode, inhibitors such as process products 28a and bubbles 28b (see FIG. 4A) are drawn together with the liquid. Thus, the inhibitors 28a, 28b which inhibit the movement of ions can immediately be removed from the surface of the workpiece 10. Therefore, the surface of the workpiece 10 can uniformly be processed without influence of the inhibitors.

According to a preferred aspect of the present invention, the electrolytic processing apparatus further comprises an ion exchanger disposed in at least one of spaces between the workpiece and the processing electrode and between the workpiece and the feeding electrode.

The partition wall preferably has an ion permeability, and more preferably has an ion-exchange ability. Further, it is desirable that the partition wall comprises an ion exchange membrane. More preferably, the partition wall has a cation-exchange ability when the ion exchanger has a cation-exchange ability, and has an anion-exchange ability when the ion exchanger has an anion-exchange ability.

A liquid may be supplied onto at least one of the processing electrode and the feeding electrode through a liquid supply hole defined in at least one of the processing electrode and the feeding electrode.

The liquid supplied through the liquid supply hole defined in at least one of the processing electrode and the feeding electrode is passed through the partition wall and supplied onto the workpiece.

The liquid may be supplied onto at least one of the processing electrode and the feeding electrode from the exterior of the processing electrode and the feeding electrode.

The liquid may be supplied onto the workpiece from the exterior of the processing electrode and the feeding electrode.

The liquid may comprise at least one of pure water, ultrapure water, and liquid having an electric conductivity of not more than 500 µS/cm. The liquid having an electric conductivity of not more than 500 µS/cm preferably includes a nonionic surfactant.

The present invention provides still another electrolytic processing method, comprising: disposing a processing electrode and a feeding electrode; applying a voltage between the processing electrode and the feeding electrode; bringing a workpiece into contact with or close to the processing electrode; isolating a liquid flowing on at least one of the processing electrode and the feeding electrode and a liquid flowing on the workpiece from each other; and processing a surface of the workpiece while the workpiece and the processing electrode are being moved relatively to each other.

The above and other objects, features, and advantages of the present invention will be apparent from the following description when taken in conjunction with the accompanying drawings which illustrates preferred embodiments of the present invention by way of example.

### Brief Description of Drawings

FIGS. 1A through 1C are diagrams illustrating, in sequence of process steps, for forming of copper interconnects;
FIG..2 is a diagram illustrating the principle of electrolytic processing when an ion exchanger is mounted on both of a processing electrode and a feeding electrode, and a liquid is supplied between the processing electrode, the feeding electrode and a substrate (workpiece);
FIG. 3 is a diagram illustrating the principle of electrolytic processing when an ion exchanger is mounted only on a processing electrode, and a liquid is supplied between the processing electrode and a substrate (workpiece);
FIG. 4A is a diagram illustrating the influence of the inhibitors when liquid suction holes are not formed in a processing electrode and a partition wall is not provided;
FIG. 4B is a diagram illustrating the function of electrolytic processing when liquid suction holes are formed in a processing electrode;
FIG. 5 is a diagram illustrating the function of electrolytic processing when a partition wall is provided;
FIG. 6 is a vertical sectional front view of an electrolytic processing apparatus according to one embodiment of the present invention;
FIG. 7 is a plan view of the electrolytic processing apparatus of FIG. 6;
FIG. 8 is an enlarged sectional view of the main portion of FIG. 6;
FIG. 9 is a plan view showing the layout of a substrate processing apparatus provided with the electrolytic processing apparatus according to an embodiment of the present invention;
FIG. 10 is a vertical sectional front view of an electrolytic processing apparatus according to another embodiment of the present invention;
FIG. 11 is a plan view of the electrolytic processing apparatus of FIG. 10;
FIG. 12 is a vertical sectional front view of an electrolytic processing apparatus according to still another embodiment of the present invention;
FIG. 13 is a plan view of the electrolytic processing apparatus of FIG. 12;
FIG. 14 is a vertical sectional front view of an electrolytic processing apparatus according to still another embodiment of the present invention;
FIG. 15 is a plan view of the electrolytic processing apparatus of FIG. 14;
FIG. 16 is a vertical sectional front view of an electrolytic processing apparatus according to still another embodiment of the present invention;
FIG. 17 is a plan view of the electrolytic processing apparatus of FIG. 16;
FIG. 18 is a perspective view of another ion exchanger;
FIG. 19A is a perspective view of still another ion exchanger;
FIG. 19B is an enlarged sectional view of a part of FIG. 19A;
FIG. 20 is a plan view of still another ion exchanger;
FIG. 21 is a perspective view of still another ion exchanger;
FIG. 22 is a plan view showing the layout of a substrate processing apparatus provided with the electrolytic processing apparatus according to another embodiment of the present invention;
FIG. 23 is a vertical sectional front view of an electrolytic processing apparatus of FIG. 22;
FIG 24A is a plan view showing the rotation-prevention mechanisms of the electrolytic processing apparatus of FIG. 23;
FIG 24B is a sectional view taken along the line A-A of FIG 24A;
FIG. 25 is a schematic sectional view of the substrate holder and the electrode section of the electrolytic processing apparatus of FIG. 23;
FIG. 26 is a plan view of the electrode section of FIG. 23;
FIGS. 27A and 27B are graphs showing the relationship between the electric current and time, and the relationship between the voltage applied and time, respectively, in electrolytic processing conducted to the surface of a substrate in which a laminated film of two different materials is formed;
FIG. 28 is a vertical sectional front view of an electrolytic processing apparatus according to still another embodiment of the present invention;
FIG. 29 is a plan view of the electrolytic processing apparatus of FIG. 28;
FIG. 30 is a vertical sectional view of an electrode section of the electrolytic processing apparatus according to still another embodiment of the present invention;
FIG. 31 is a vertical sectional view of a substrate holder and an electrode section of the electrolytic processing apparatus according to still another embodiment of the present invention;
FIG. 32 is a vertical sectional front view of an electrolytic processing apparatus according to still another embodiment of the present invention;
FIG. 33 is a plan view of the electrode section of FIG. 32; and
FIG. 34 is a vertical sectional view of a substrate holder and an electrode section of the electrolytic processing apparatus according to still another embodiment of the present invention.

### Best Mode for Carrying Out the Invention

Preferred embodiments of the present invention will now be described with reference to the drawings. Though the below-described embodiments refer to application to electrolytic processing apparatuses which use a substrate as a workpiece to be processed and remove (polish) copper formed on the surface of the substrate, the present invention is of course applicable to processing apparatuses which process a workpiece other than a substrate, and to other electrolytic process.

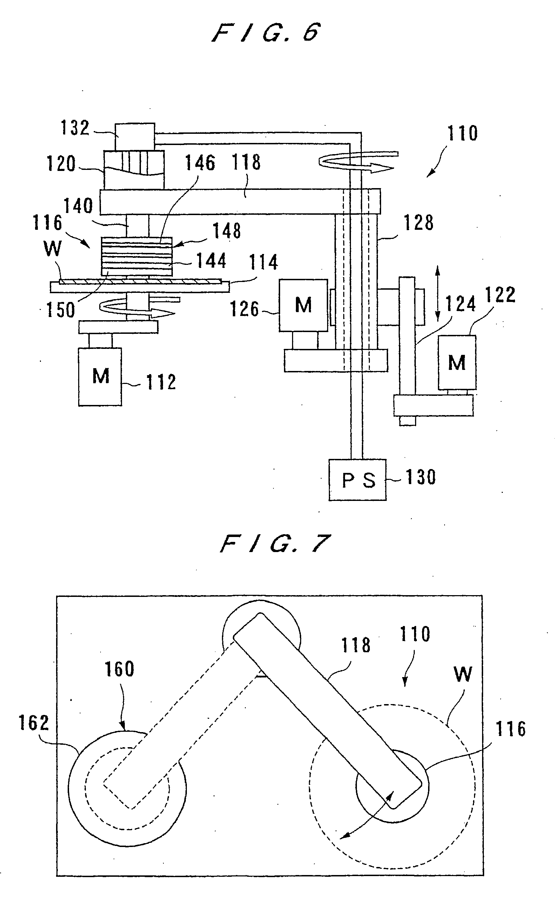

FIGS. 6 through 8 show an electrolytic processing apparatus according to an embodiment of the present invention. As shown in FIG. 6, the electrolytic processing apparatus 110 includes a substrate holder 114 that can swing horizontally by the actuation of a motor 112 for rotation, and a disc-shaped electrode section 116 positioned beneath the substrate holder 114. This electrolytic processing apparatus 110 employs, as the electrode section 116, such one that has a sufficiently smaller diameter than that of the substrate W held by the substrate holder 114 so that the surface of the substrate may not be entirely covered with the electrode section 116. The positional relationship between the substrate W and process portion, shown in. FIG. 6, may be reversed so that the surface of the substrate faces upward (face-up).

The electrode section 116 is coupled to the hollow motor 120 and supported at a free end of a swingable arm 118, and is allowed to rotate by the actuation of the hollow motor 120. The swingable arm 118 , which moves up and down via a ball screw 124. by the actuation of a motor 122 for vertical movement, is connected to the upper end of a shaft 128 that rotates by the actuation of a motor 126 for swinging. Further, wires extending from the power source 130 pass through a hollow portion formed in the shaft 128 and reach the slip ring 132, and further pass through the hollow portion of the hollow motor 120 and reach a pair of electrodes 144, 146 to apply a voltage therebetween as described below.

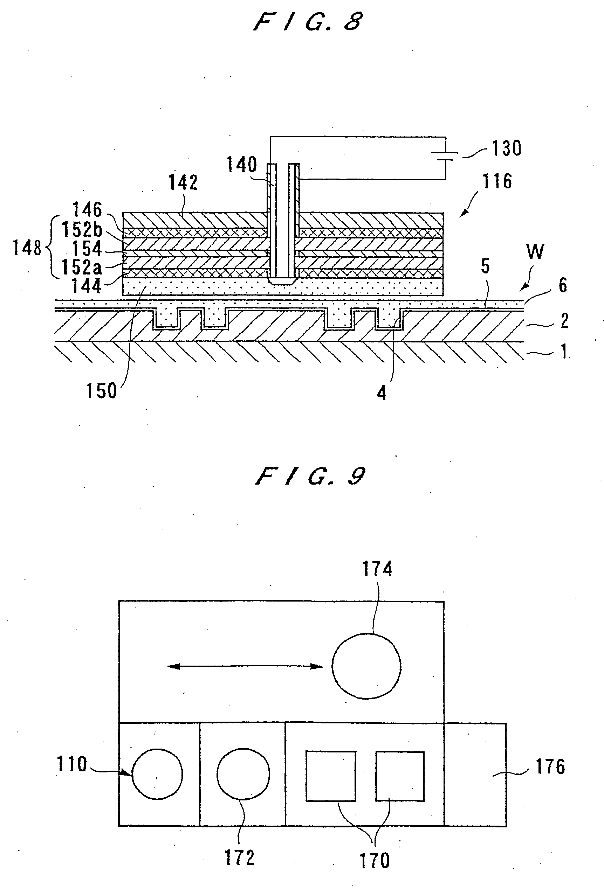

As shown in FIG. 8, the electrode section 116 has a hollow rotating shaft 140 extending from the hollow motor 120. To the rotating shaft 140 are fixed a disc-shaped base plate 142 and, positioned below the base plate 142, a pair of disc-shaped electrodes 144, 146 composed of e.g. a mesh and disposed in parallel at a given distance. An ion exchanger 148 having water-absorbing properties is interposed between the electrodes 144, 146, and the exposed surface (lower surface) of the electrode 144 to be opposed to the substrate W is covered with a water-permeable pad 150. Further, the rotating shaft 140 has holes in its portion opposed to the ion exchanger 148. According to this embodiment, an anode and a cathode are disposed on the same side of the workpiece.

Pure water, preferably ultrapure water, is supplied from the outside into the hollow portion of the rotating shaft 140, reaches the inside of the ion exchanger 148, flows within the ion exchanger 148, passed through the pad 150, and is supplied to the surface of the substrate W held on the substrate holder 114. Further, electricity is fed to the electrodes 144, 146 through the outer circumferential surface of the rotating shaft 140.

According to this embodiment, one electrode 144, disposed in a lower position and opposed to the substrate W held on the substrate holder 114, is connected to an anode extending from the power source 130 and becomes an anode, and the other electrode 146 is connected to a cathode extending from the power source 130 and becomes a cathode. Further, the ion-exchanger 148 is of a three-layer structure consisting of a pair of strongly acidic cation-exchange fibers 152a, 152b and a strongly acidic cation-exchange membrane 154 interposed between the fibers 152a, 152b. The holes of the rotating shaft 140 are opposed to the cation-fibers 152a, 152b.

The ion exchanger 148 may be a nonwoven fabric which has an anion-exchange ability or a cation-exchange ability. A cation exchanger preferably carries a strongly acidic cation-exchange group (sulfonic acid group) ; however, a cation exchanger carrying a weakly acidic cation-exchange group (carboxyl group) may also be used. Though an anion exchanger preferably carries a strongly basic anion-exchange group (quaternary ammonium group), an anion exchanger carrying a weakly basic anion-exchange group (tertiary or lower amino group) may also be used.

The nonwoven fabric carrying a strongly basic anion-exchange group can be prepared by, for example, the following method: A polyolefin nonwoven fabric having a fiber diameter of 20-50 µm and a porosity of about 90 % is subjected to the so-called radiation graft polymerization, comprising γ-ray irradiation onto the nonwoven fabric and the subsequent graft polymerization, thereby introducing graft chains; and the graft chains thus introduced are then aminated to introduce quaternary ammonium groups thereinto. The capacity of the ion-exchange groups introduced can be determined by the amount of the graft chains introduced. The graft polymerization may be conducted by the use of a monomer such as acrylic acid, styrene, glicidyl methacrylate, sodium styrenesulfonate or chloromethylstyrene. The amount of the graft chains can be controlled by adjusting the monomer concentration, the reaction temperature and the reaction time. Thus, the degree of grafting, i.e. the ratio of the weight of the nonwoven fabric after graft polymerization to the weight of the nonwoven fabric before graft polymerization, can be made 500 % at its maximum. Consequently, the capacity of the ion-exchange groups introduced after graft polymerization can be made 5 meq/g at its maximum.

The nonwoven fabric carrying a strongly acidic cation-exchange group can be prepared by the following method: As in the case of the nonwoven fabric carrying a strongly basic anion-exchange group, a polyolefin nonwoven fabric having a fiber diameter of 20-50 µm and a porosity of about 90 % is subjected to the so-called radiation graft polymerization comprising γ-ray irradiation onto the nonwoven fabric and the subsequent graft polymerization, thereby introducing graft chains; and the graft chains thus introduced are then treated with a heated sulfuric acid to introduce sulfonic acid groups thereinto. If the graft chains are treated with a heated phosphoric acid, phosphate groups can be introduced. The degree of grafting can reach 500 % at its maximum, and the capacity of the ion-exchange groups thus introduced after graft polymerization can reach 5 meq/g at its maximum.

The base material of the ion-exchanger 148 may be a polyolefin such as polyethylene or polypropylene, or any other organic polymer. Further, besides the form of a nonwoven fabric, the ion-exchanger may be in the form of a woven fabric, a sheet, a porous material, short fibers, etc.

When polyethylene or polypropylene is used as the base material, graft polymerization can be effected by first irradiating radioactive rays (γ-rays or electron beam) onto the base material (pre-irradiation) to thereby generate a radical, and then reacting the radical with a monomer, whereby uniform graft chains with few impurities can be obtained. When an organic polymer other than polyolefin is used as the base material, on the other hand, radical polymerization can be effected by impregnating the base material with a monomer and irradiating radioactive rays (γ -rays, electron beam or UV-rays) onto the base material (simultaneous irradiation) . Though this method fails to provide uniform graft chains, it is applicable to a wide variety of base materials.

By using as the ion exchanger 148 a nonwoven fabric having an anion-exchange ability or a cation-exchange ability, it becomes possible that pure water or ultrapure water, or a liquid such as an electrolytic solution can freely move within the nonwoven fabric and easily arrive at the active points in the nonwoven fabric having a catalytic activity for water dissociation, so that many water molecules are dissociated into hydrogen ions and hydroxide ions. Further, by the movement of pure water or ultrapure water, or a liquid such.as an electrolytic solution, the hydroxide ions produced by the water dissociation can be efficiently carried to the surface of the substrate W, whereby a high electric current can be obtained even with a low voltage applied.

When the ion exchanger 148 has only one of anion-exchange ability and cation-exchange ability, a limitation is imposed on electrolytically processible materials and, in addition, impurities are likely to form due to the polarity. In order to solve this problem, the ion exchanger 148 may have such a structure wherein anion-exchangers having an anion-exchange ability and cation-exchangers having a cation-exchange ability are concentrically disposed to constitute an integral structure. The anion exchangers and the cation exchangers may be superimposed on the surface, to be processed, of a substrate. It may also be possible to make the anion-exchangers and the cation-exchangers each in the shape of a fan, and dispose them alternately. Alternatively, the ion exchanger 148 may carry both of an anion-exchange group and a cation-exchange group per se. Such an ion exchanger may include an amphoteric ion exchanger in which anion-exchange groups and cation-exchange groups are distributed randomly, a bipolar ion exchanger in which anion-exchange groups and cation-exchange groups are present in layers, and a mosaic ion exchanger in which portions containing anion-exchange groups and portions containing cation-exchange groups are present in parallel in the thickness direction. Incidentally, it is of course possible to selectively use, as the ion exchange 148, one having an anion exchange ability or one having a cation-exchange ability according to the material to be processed.

Further, by making the ion exchanger 148 a multi-layer structure consisting of laminated layers of ion-exchange materials, such as a nonwoven fabric, a woven fabric and a porous membrane, it is possible to increase the total ion exchange capacity whereby formation of an oxide, for example in removal (polishing) processing of copper, can be restrained to thereby avoid the oxide adversely affecting the processing rate. Not the use of a multi-layer structure, but the use of a single-layer ion exchanger with an increased thickness can also increase the ion exchange capacity. In this regard, when the total ion exchange capacity of an ion exchanger is smaller than the amount of copper ions taken in the ion exchanger during removal processing, the oxide should inevitably be formed on the surface or in the inside of the ion exchanger, which adversely affects the processing rate. Thus, the formation of the oxide is governed by the ion exchange capacity of an ion exchanger, and copper ions exceeding the capacity should become the oxide. The formation of an oxide can thus be effectively restrained by using, as the ion exchanger 148, a multi-layer ion exchanger composed of laminated layers of ion-exchange materials which has enhanced total ion exchange capacity. The formation of an oxide can also be restrained by regenerating the ion exchanger so as to suppress accumulation of copper ions within the ion exchanger.

By covering the exposed surface of the electrode 144 with a water-permeable member 150, direct contact between the electrode 144 and the to-be-processed material can be avoided, whereby the mechanical life of the electrode 144 itself can be prolonged. Further, by supplying a slurry from the outside, a CMP processing can be carried out simultaneously

Further according to this embodiment, the ion exchanger 148 (strongly acidic cation-exchange fibers 152b) is not in contact with the workpiece. This can suppress production of fiber dust due to friction between the ion-exchanger 148 and the to-be-processed material and prolong the mechanical life of the ion exchanger 148 itself.

The ion exchanger 148 and the water-permeable member 150 should meet the following requisites:

### (1) Removal of processing products (including a gas)

This is closely related to stability of the processing rate and evenness in the distribution of processing rate. To meet this demand, it is preferable to use an ion-exchange material having "water permeability" and "water absorbing properties". By the term "water permeability" is herein meant a permeability in a broad sense. Thus, the member 150, which itself has no water permeability but can permit permeation therethrough of water by the provision of holes or grooves, is herein included as a "water-permeable" member. The term "water-absorbing properties" means properties of absorbing water and allowing water to penetrate into the material.

### (2) Stability of processing rate

To meet this demand, it is desirable to make a single-layer ion exchanger thicker or use a multi-layer laminated ion exchanger, thereby securing an adequate ion-exchange capacity.

### (3) Flatness of processed surface (ability of eliminating steps)

To meet this demand, the processing surface of the member 150 desirably has a surface smoothness. Further, in general, the harder the member is, the flatter is the processed surface (ability of eliminating steps).

### (4) Long life

In the light of long mechanical life of the member 150, it is desirable to use an ion-exchange material having.a high wear resistance.

Accordingly, as a material for the ion exchanger for use as an OH-supply type processing device between the electrodes, it is desirable to use a "air-permeable ion-exchange material (nonwoven fabric)". Such a material should preferably have "water-absorbing properties".

As regards the member (processing member) 150 for use between the electrode and the workpiece, it is desirable to use a "water-permeable material (including an ion-exchange material)", and more desirably "water-permeable, wear-resistant material (including an ion-exchange material)". For example, a commercially-available foamed polyurethane "IC 1000" (manufactured by Rodel, Inc.), generally employed as a pad for CMP, is hard and excellent in wear resistance. By providing a number of through-holes , this product can be used as a processing member disposed between the electrode and the workpiece. It is possible to provide holes in a resin plate, thereby making the plate water-permeable for use as the member. It is of course desirable that the resin have "water-absorbing properties".

As shown in FIG. 7, a regeneration section 160 for regenerating the ion exchanger 148 of the electrode section 116 is disposed beside the substrate holder 114. The regeneration section 160 includes a regeneration tank 162 filled with e.g. a dilute acid solution. In operation, the electrode section 148 is moved by the swingable arm 118 to a position right above the regeneration tank 162, and is then lowered so that at least the ion exchanger 148 of the electrode section 160 is immersed in the acid solution in the regeneration tank 162. Thereafter, the reverse electric potential to that for processing is given to a pair of electrode 144, 145, thereby promoting dissolution of extraneous matter such as copper adhering to the ion exchanger 148 to thereby regenerate the ion exchanger 148. The regenerated ion exchanger 148 is rinsed by e.g. ultrapure water.

A description will now be given of an example of processing by the electrolytic processing apparatus 110.

First, a substrate W, e.g. a substrate in which trenches 4 for interconnects have been formed in insulating film 2, such as SiO₂, deposited on semiconductor base 1, and copper film 6 has then been formed over the entire surface, is held on the substrate holder 114. Next, the electrode section 116 is pivoted to above the substrate holder 114, and then lowered so as to bring the pad 150 close to or into contact with the surface of the substrate W.

While applying a predetermined voltage between the pair of electrodes 144, 146, the substrate holding portion 114 is rotated, and the electrode section 116 is rotated and pivoted in such a range that it does not move out of the substrate W held in the substrate holder 114. At the same, pure water or ultrapure water is supplied from above the electrode section 116, through the hollow portion of the rotating shaft 140, to the ion exchanger 148 of the electrode section 116, thereby filling the inside of the ion exchanger 148 with pure water or ultrapure water. Pure water or ultrapure water is supplied to the ion exchanger 148 by the centrifugal force due to rotation of the electrode section 116. Pure water or ultrapure water, which has passed through the ion exchanger 148, is supplied to the surface of the substrate W to effect removal (polishing) processing of the copper film 6 of the substrate W.

Thus, pure water or ultrapure water is dissociated through the catalytic reaction in the ion exchanger 148 into OH⁻ ions and H⁺ ions. The OH⁻ ions transfer the electric charge in the vicinity of the anode (electrode 144) and become OH radicals. The OH radicals act on the copper film 6 of the substrate W. Removal (polishing) processing of the copper film 6 is thus effected. The H₂ gas generated at the cathode (electrode 146) is shut off by the strongly acidic cation-exchange membrane 154, and is removed to the outside by the flow of pure water or ultrapure pure caused by the centrifugal force due to rotation of the electrode 116, whereby the H₂ gas is prevented from interrupting the removal processing action.

The fundamental difference between an ion-exchange membrane and ion-exchange fibers resides in the difference of the basic material that carries ion-exchange groups (catalytic effect on the promotion of water dissociation reaction is basically the same). The primary difference for the present invention is the difference in water permeability. Thus, an ion-exchange membrane, because of the membrane form (like an OHP sheet) is poor in water permeability and thus has a low permeability to the gas generated in the electrode reaction. In contrast, ion-exchange fibers, because of the form of fibers or fabric (like a gauze), is excellent in water permeability and thus has a high permeability to the gas generated in the electrode reaction. According to the present invention, an ion-exchange membrane can thus be inserted between the electrodes in order to shut off the gas generated at the cathode (but permit permeation of ions).

More specifically, by allowing pure water or ultrapure water to flow within the ion exchanger 148, a sufficient amount of water can be supplied to a functional group (sulfonic acid group in the case of an ion exchanger carrying a strongly acidic cation-exchange group) thereby to increase the amount of dissociated water molecules, and the process product (including a gas) formed by the reaction between the conductor film (copper film 6) and hydroxide ions (or OH radicals) can be removed by the flow of water, whereby the processing efficiency can be enhanced. The flow of pure water or ultrapure water is thus necessary, and the flow of water should desirably be constant and uniform. The constancy and uniformity of the flow of water leads to constancy and uniformity in the supply of ions and the removal of the process product, which in turn leads to constancy and uniformity in the processing.

According to this embodiment, since the pair of electrodes 144, 146 are disposed in parallel, the electric field between the electrodes 144, 146 becomes uniform. Accordingly, the catalytic reaction takes place evenly over the entire electrode, leading to evenness in the supply of OH⁻ ions.

After completion of the electrolytic processing, the power source 130 is disconnected, supplying pure water or ultrapure water is stopped, the rotation of the substrate holder 114 is stopped, and rotation and swinging of the electrode section 116 is stopped. Thereafter, the electrode section 116 is raised, and processed substrate W held by the substrate holder 114 is transferred to next process.

This embodiment shows the case of supplying pure water, preferably ultrapure water, to the ion exchanger 148. The use of pure water or ultrapure water containing no electrolyte upon electrolytic processing can prevent impurities such as an electrolyte from adhering to and remaining on the surface of the substrate W. Further, copper ions or the like dissolved during electrolytic processing are immediately caught by the ion exchanger 148 through the ion-exchange reaction. This can prevent the dissolved copper ions or the like from reprecipitating on the other portions of the substrate W, or from being oxidized to become fine particles which contaminate the surface of the substrate W.

Ultrapure water has a high resistivity, and therefore an electric current is hard to flow therethrough. A lowering of the electric resistance is made by interposing the ion exchanger 148 between the pair of electrodes 144, 146. Further, an electrolytic solution, when used in combination with ultrapure water, can further lower the electric resistance and reduce the power consumption. When electrolytic processing is conducted by using an electrolytic solution, the portion of a workpiece that undergoes processing ranges over a slightly wider area than the area of the processing electrode. In the case of the combined use of ultrapure water and the ion exchanger, on the other hand, since almost no electric current flows through ultrapure water, electric processing is effected only within the area of a workpiece that is equal to the area of the processing electrode and the ion exchanger.

It, is possible to use, instead of pure water or ultrapure water, an electrolytic solution obtained by adding an electrolyte to pure water or ultrapure water. The use of such an electrolytic solution can further lower the electric resistance and reduce the power consumption. A solution of a neutral salt such as NaCl or Na₂SO₄, a solution of an acid such as HCl or H₂SO₄, or a solution of an alkali such as ammonia, may be used as the electrolytic solution, and these solutions may be selectively used according to the properties of the workpiece . When the electrolytic solution is used, it is preferred to provide a slight interspace between the substrate W and the electrode section 116 so that they are not in contact with each other. To avoid contamination of the wafer induced by an electrolytic solution, it is better to use an dilute electrolytic solution which electric conductivity is not more than 500 µs/cm. Therefore, the cleanliness of the processed workpiece can be increased.

Further, it is also possible to use, instead of pure water or ultrapure water, a liquid obtained by adding a surfactant to pure water or ultrapure water, and having an electric conductivity of not more than 500 µS/cm, preferably not more than 50 µS/cm, more preferably not more than 0.1 µS/cm (resistivity of not less than 10 MΩ · cm). Due to the presence of a surfactant, the liquid can form a layer, which functions to inhibit ion migration evenly, at the interface between the substrate W and the electrode section 116, thereby moderating concentration of ion exchange (metal dissolution) to enhance the flatness of the processed surface. The surfactant concentration is desirably not more than 100 ppm. When the value of the electric conductivity is too high, the current efficiency is lowered and the processing rate is decreased. The use of the liquid having an electric conductivity of not more than 500 µS/cm, preferably not more than 50 µS/cm, more preferably not more than 0.1 µS/cm, can attain a. desired processing rate.

According to the present invention, the processing rate can be considerably enhanced by interposing the ion exchanger 148 between the pair of electrodes 144, 146. In this regard, electrochemical processing using ultrapure water is effected by a chemical interaction between hydroxide ions in ultrapure water and a material to be processed. However, the amount of the hydroxide ions acting as reactant in ultrapure water is as small as 10⁻⁷ mol/L under normal temperature and pressure conditions, so that the removal processing efficiency can decrease due to reactions (such as an oxide film-forming reaction) other than the reaction for removal processing. It is therefore necessary to increase hydroxide ions in order to conduct removal processing efficiently. A method for increasing hydroxide ions is to promote the dissociation reaction of ultrapure water by using a catalytic material, and an ion exchanger can be effectively used as such a catalytic material. More specifically, the activation energy relating to water-molecule dissociation reaction is lowered by the interaction between functional groups in an ion exchanger and water molecules, whereby the dissociation of water is promoted to thereby enhance the processing rate.

Further, according to this embodiment, the electrode section 116 is brought into contact with or close to the substrate W upon electrolytic processing. When the electrode section 116 is positioned close to the substrate W, though depending on the distance therebetween, the electric resistance is large to some degree and, therefore, a somewhat large voltage is necessary to provide a requisite electric current density. However on the other hand, because of the non-contact relation, it is easy to form flow of pure water or ultrapure water along the surface of the substrate W, whereby the reaction product produced on the substrate surface can be efficiently removed. In the case where the electrode section 116 is brought into contact with the substrate W, the electric resistance becomes very small and therefore only a small voltage needs to be applied, whereby the power consumption can be reduced.

If a voltage is raised to increase the current density in order to enhance the processing rate, an electric discharge can occur when the electric resistance between the electrode and the substrate (workpiece) is large. The occurrence of electric discharge causes pitching on the surface of the workpiece, thus failing to form an even and flat processed surface. To the contrary, since the electric resistance is very small when the electrode section 116 is in contact with the substrate W, the occurrence of an electric discharge can be avoided.

When electrolytic processing of copper is conducted by using, as the ion exchanger 148, an ion exchanger having a cation-exchange group, the ion-exchange group of the ion exchanger (cation exchanger) 148 is saturated with copper after the processing, whereby the processing efficiency of the next processing is lowered. When electrolytic processing of copper is conducted by using, as the ion exchanger 148, an ion exchanger having an anion-exchange group, fine particles of a copper oxide can be produced and adhere to the surface of the ion exchanger (anion exchanger) 148, which particles can contaminate the surface of a next substrate to be processed.

In order to obviate such drawbacks, a regeneration section 160 for regenerating the ion exchanger 148 is provided, and the regeneration of the ion exchanger 148 can be effected during electrolytic processing.

FIG. 9 shows an example of a substrate processing apparatus provided with the electrolytic processing apparatus 110 according to an embodiment of the present invention. As shown in FIG. 9, the substrate processing apparatus comprises a pair of loading/unloading units 170 as a carry-in and carry-out section for carrying in and carrying out a cassette housing a substrate W, e.g. a substrate W as shown in FIG. 1B, which has in its surface a copper film 6 as a conductor film (portion to be processed), a reversing machine 172 for reversing the substrate W, and an electrolytic processing apparatus 110, which are disposed in series. A transfer robot 174 as a transfer device is provided which can move parallel to these apparatuses for transporting and transferring the substrate W therebetween. The substrate processing apparatus is also provided with a monitor 176 for monitoring a voltage applied between the pair of electrodes 144, 146 upon electrolytic processing in the electrolytic processing apparatus 110, or an electric current flowing therebetween.

Next, substrate processing (electrolytic processing) by the substrate processing apparatus will be described.

First, a substrate W, e.g. a substrate Was shown in FIG. 1B which has in its surface a copper film 6 as a conductor film (portion to be processed), is taken by the transfer robot 174 out of the cassette housing substrates and set in the loading/unloading unit 170. If necessary, the substrate W is transferred to the reversing machine 172 to reverse the substrate W. The substrate W is then attracted and held by the substrate holder 114 of the electrolytic processing apparatus 110. Then, the electrolytic processing can be conducted as the same manner described above.

The monitor 176 monitors the voltage applied between the pair of electrodes 144, 146 or the electric current flowing therebetween to detect the end point (terminal of processing) . It is noted in this connection that in electrolytic processing an electric current (applied voltage) varies, depending upon the material to be processed, even with the same voltage (electric current). Therefore, the end point can surely be detected by the monitoring of changes in electric current or in voltage.

After completion of the electrolytic processing, the substrate holder 114 is raised, and substrate W is carried to the transfer robot 174 by swinging the swingable arm 118. The transfer robot 174 takes the substrate W from the substrate holder 114 and, if necessary, transfers the substrate W to the reversing machine 32 for reversing it, and then returns the substrate W to the cassette in the loading/unloading unit 170.

According to this embodiment, unlike a CMP processing, electrolytic processing of a workpiece, such as a substrate, can be effected through electrochemical action without causing any physical defects in the workpiece that would impair the properties of the workpiece. The electrolytic processing apparatus can effectively remove (clean) matter adhering to the surface of the workpiece such as a substrate. Accordingly, the apparatus can omit a CMP treatment entirely or at least reduce a load upon CMP. Furthermore, the electrolytic processing of a substrate can be effected even by solely using pure water or ultrapure water. This obviates the possibility that impurities such as an electrolyte will adhere to or remain on the surface of the substrate, can simplify a cleaning process after the removal processing, and can remarkably reduce a load upon waste liquid disposal.

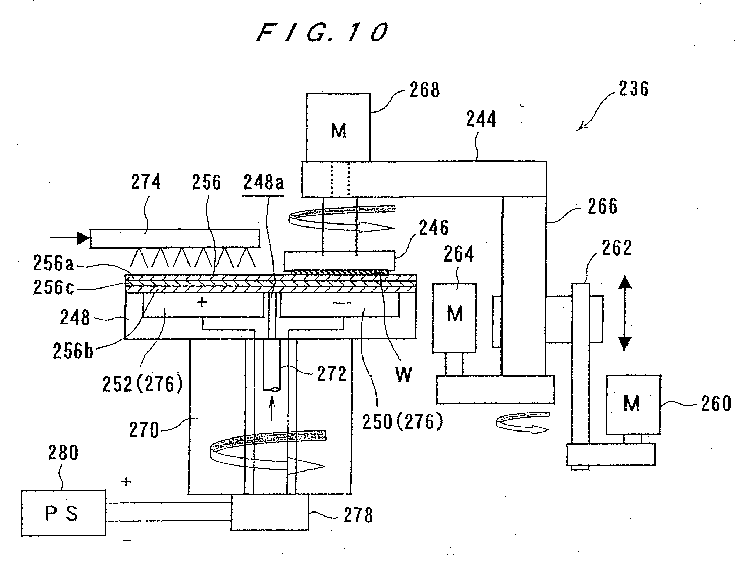

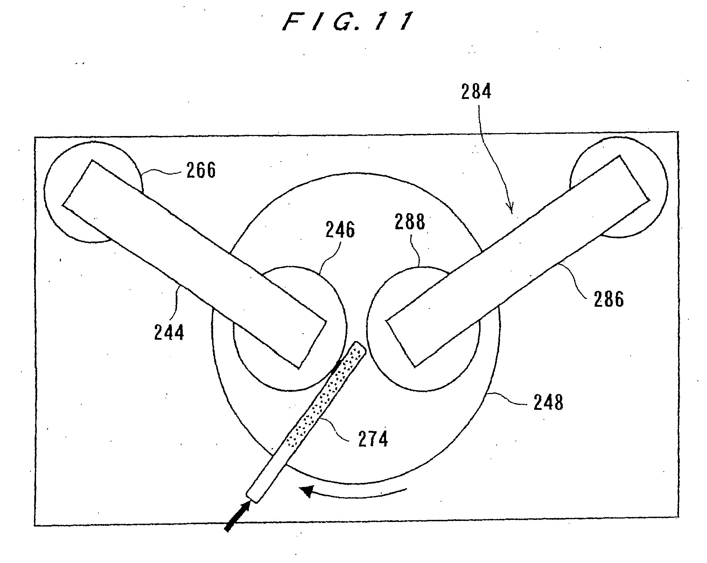

FIGS. 10 and 11 show an electrolytic processing apparatus according to another embodiment of the present invention. This electrolytic processing apparatus 236 includes a substrate holder 246, supported at the free end of a swingable arm 244 that can swing horizontally, for attracting and holding the substrate W with its front surface downward (so-called "face-down" manner), and, positioned beneath the substrate holder 246, a disc-shaped electrode section 248 made of an insulating material. The electrode section 248 has, embedded therein, fan-shaped processing electrodes 250 and feeding electrodes 252 that are disposed alternately with their surfaces (upper faces) exposed. A film-like ion exchanger 256 consisting of laminated layers (lamination) is mounted on the upper surface of the electrode section 248 so as to cover the surfaces of the processing electrodes 250 and the feeding electrodes 252.

This embodiment uses, merely as an example of the electrode section 248 having the processing electrodes 250 and the feeding electrodes 252, such one that has a diameter more than twice that of the substrate W so that the entire surface of the substrate W may undergo electrolytic processing.

The swingable arm 244, which moves up and down via a ball screw 262 by the actuation of a motor 260 for vertical movement, is connected to the upper end of a shaft 266 that rotates by the actuation of a motor 264 for swinging. The substrate holder 246 is connected to a motor 268 for rotation that is mounted on the free end of the swingable arm 244, and is allowed to rotate by the actuation of the motor 268 for rotation.

The electrode section 248 is connected directly to a hollow motor 270 , and is allowed to rotate by the actuation of the hollow motor 270. A through-hole 248a as a pure water supply section for supplying pure water, preferably ultrapure water, is formed in the central portion of the electrode section 248. The through-hole 248a is connected to a pure water supply pipe 272 that vertically extends inside the hollow motor 270. Pure water or ultrapure water is supplied through the through-hole 248a, and via the ion exchanger 256, is supplied to the entire processing surface of the substrate W. A plurality of through-holes 248a, each communicating with the pure water supply pipe 272, may be provided to facilitate the processing liquid reaching over the entire processing surface of the substrate W.

Further, a pure water nozzle 274 as a pure water supply section for supplying pure water or ultrapure water, extending in the radial direction of the electrode section 248 and having a plurality of supply ports, is disposed above the electrode section 248. Pure water or ultrapure water is thus supplied to the surface of the substrate W from above and beneath the substrate W. Pure water herein refers to a water having an electric conductivity of not more than 10 µS/cm, and ultrapure water refers to a water having an electric conductivity of not more than 0.1 µS/cm. Instead of pure water, a liquid having an electric conductivity of not more than 500 µS/cm or any electrolytic solution may be used. By supplying such a processing liquid during processing, the instability factors of processing, such as process products and dissolved gases, can be removed, and processing can be effected uniformly with good reproducibility.

According to this embodiment, fan-shaped electrode plates 276 are disposed in the electrode section 248, and the cathode and anode of a power source 280 are alternately connected, via a slip ring 278, to the electrode plates 276. The electrode plates 276 connected to the cathode of the power source 280 become the processing electrodes 250 and the electrode plates 276 connected to the anode of the power source 280 become the feeding electrodes 252. This applies to processing of e.g. copper, because electrolytic processing of copper proceeds on the cathode side. Depending upon a material to be processed, the cathode side can be a feeding electrode and the anode side can be a processing electrode. More specifically, when the material to be processed is copper, molybdenum, iron or the like, electrolytic processing proceeds on the cathode side, and therefore the electrode plates 276 connected to the cathode of the power source 280 should be the processing electrodes 250 and the electrode plates 276 connected to the anode should be the feeding electrodes 252. In the case of aluminum, silicon or the like, on the other hand, electrolytic processing proceeds on the anode side. Accordingly, the electrode plates connected to the anode of the power source should be the processing electrodes and the electrode plates connected to the cathode should be the feeding electrodes.

By thus disposing the processing electrodes 250 and the feeding electrodes 252 separately and alternately in the circumferential direction of the electrode section 248, fixed feeding portions to supply electricity to a conductive film (portion to be processed) of the substrate is not needed, and processing can be effected to the entire surface of the substrate. Further, be changing the positive and negative in a pulse manner, an electrolysis product can be dissolved and the flatness of the processed surface can be enhanced by the multiplex repetition of processing.

With respect to the processing electrode 250 and the feeding electrode 252, oxidation or dissolution thereof due to an electrolytic reaction is generally a problem. In view of this, it is preferred to use, as a base material of the feeding electrode 252, carbon, a noble metal that is relatively inactive, a conductive oxide or a conductive ceramics, rather than a metal or metal compound widely used for electrodes. A noble metal-based electrode may, for example, be one obtained by plating or coating platinum or iridium onto a titanium electrode, and then sintering the coated electrode at a high temperature to stabilize and strengthen the electrode. Ceramics products are generally obtained by heat-treating inorganic raw materials, and ceramics products having various properties are produced from various raw materials including oxides, carbides and nitrides of metals and nonmetals. Among them there are ceramics having an electric conductivity. When an electrode is oxidized, the value of the electric resistance generally increases to cause an increase of applied voltage. However, by protecting the surface of an electrode with a non-oxidative material such as platinum or with a conductive oxide such as an iridium oxide, the decrease of electric conductivity due to oxidation of the base material of an electrode can be prevented.

The ion-exchanger 256 is of a three-layer structure (lamination) consisting of a pair of strongly acidic cation-exchange fibers 256a, 256b and a strongly acidic cation-exchange membrane 256c interposed between the fibers 256a, 256b.

The ion exchanger (laminate) 256 has a good water permeability and a high hardness and, in addition, the exposed surface (upper surface) to be opposed to the substrate W has a good smoothness.

As described above, though the respective materials 256a, 256b, 256c may preferably carry a strongly acidic cation-exchange group (sulfonic acid group), they may also carry a weekly acidic cation-exchange group (carboxyl group), a strongly basic anion-exchange group (quaternary ammonium group) or a weekly basic anion-exchange group (tertiary or lower amino group).

Each of the base material of the laminated layers 256a, 256b, 256c of the ion exchange 256 may be a polyolefin such as polyethylene or polypropylene, or any other organic polymer. Further, besides the form of a nonwoven fabric, the ion-exchanger may be in the form of a woven fabric, a sheet, a porous material, short fibers, etc.

By using a nonwoven fabric having an anion-exchange ability or a cation-exchange ability as each of the laminated layers 256a, 256b, 256c of the ion exchange 256, it becomes possible that pure water or ultrapure water, or a.liquid such as an electrolytic solution can freely move within the nonwoven fabric and easily arrive at the active points in the nonwoven fabric having a catalytic activity for water dissociation, so that many water molecules are dissociated into hydrogen ions and hydroxide ions. Further, by the movement of pure water or ultrapure water, or a liquid such as an electrolytic solution, the hydroxide ions produced by the water dissociation can be efficiently carried to the surface of the substrate W, whereby a high electric current can be obtained even with a low voltage applied.

When the ion exchange 256 has only one of anion-exchange ability and cation-exchange ability, a limitation is imposed on electrolytically processible materials and, in addition, impurities are likely to form due to the polarity. In order to solve this problem, the ion exchanger 256 may have such a structure wherein anion-exchangers having an anion-exchange ability and cation-exchangers having a cation-exchange ability are concentrically disposed to constitute an integral structure. Alternatively, each of the laminated layers 256a, 256b, 256c of the ion exchange 256 may carry both of an anion-exchange group and a cation-exchange group per se. Such an ion exchanger may include an amphoteric ion exchanger in which anion-exchange groups and cation-exchange groups are distributed randomly, a bipolar ion exchanger in which anion-exchange groups and cation-exchange groups are present in layers, and a mosaic ion exchanger in which portions containing anion-exchange groups and portions containing cation-exchange groups are present in parallel in the thickness direction.

Further, by making the ion exchanger 256 a multi-layer structure consisting of laminated layers of ion-exchange materials, such as a nonwoven fabric, a woven fabric and a porous membrane, it is possible to increase the total ion exchange capacity whereby formation of an oxide, for example in removal (polishing) processing of copper, can be restrained to thereby avoid the oxide adversely affecting the processing rate. In this regard, when the total ion exchange capacity of an ion exchanger 256 is smaller than the amount of copper ions taken in the ion exchanger during removal processing, the oxide should inevitably be formed on the surface or in the inside of the ion exchanger, which adversely affects the processing rate. Thus, the formation of the oxide is governed by the ion exchange capacity of an ion exchanger, and copper ions exceeding the capacity should become the oxide. The formation of an oxide can thus be effectively restrained by using, as the ion exchanger 256, a multi-layer ion exchanger composed of laminated layers of ion-exchange materials which has enhanced total ion exchange capacity.

The ion exchanger 256 should meet the following requisites:

### (1) Removal of processing products (including a gas)

This is closely related to stability of the processing rate and evenness in the distribution of processing rate. To meet this demand, it is preferable to use an ion-exchange material having "water permeability" and "water absorbing properties". By the term "water permeability" is herein meant a permeability in a broad sense. Thus, the material, which itself has no water permeability but can permit permeation therethrough of water by the provision of holes or grooves, is herein included as a "water-permeable" member. The term "water-absorbing properties" means properties of absorbing water and allowing water to penetrate into the material.

### (2) Stability of processing rate

To meet this demand, it is desirable to use a multi-layer laminated ion exchanger, thereby securing an adequate ion-exchange capacity.

### (3) Flatness of processed surface (ability of eliminating steps)

To meet this demand, the processing surface of'the ion exchanger desirably has a surface smoothness. Further, in general, the harder the ion exchanger is, the flatter is the processed surface (ability of eliminating steps).

### (4) Long'life

In the light of long mechanical life of the ion exchanger, it is desirable to use an ion-exchange material having a high wear resistance.

Accordingly, the ion exchanger 256 should have "water permeability", and should preferably also have "water-absorbing properties". Further, it is desirable that at least the material to be opposed to the workpiece have a high hardness and good surface smoothness. For example, a commercially-available foamed polyurethane "IC 1000" (manufactured by Rodel, Inc.), generally employed as a pad for CMP, is hard and excellent in wear resistance. By providing a number of through-holes, this product can be used as a material for the ion exchanger 256. It is possible to provide holes in a resin plate, thereby making the plate water-permeable for use in the ion exchanger 256. It is of course desirable that the resin have "water-absorbing properties".

The term "high hardness" herein means a high rigidity and a low compression elastic modulus. A material having a high hardness, when used in processing of a workpiece having fine irregularities in the surface, such as a patterned wafer, hardly follows the irregularities and are likely to selectively process the raised portions of the pattern, thereby removing the raised portions.

It is desirable that a material having a high hardness be used in the outermost layer of the ion exchanger to be opposed to the workpiece.

When a plurality of different materials are used for the ion exchanger, a material having a higher hardness than the others may be used in at least one layer.

When it is desired to obtain a high hardness for the entire laminate, a plurality of the same materials having a high hardness may be laminated.

The expression "has a surface smoothness" herein means that the surface has little irregularities. A laminate having a surface smoothness, when used in processing of e.g. a patterned wafer, is less likely to contact the recesses of the pattern and therefore is more likely to selectively process and remove the raised portions. A material having a surface smoothness should preferably be used in the outermost layer of the laminate to be opposed to the workpiece. Of course, a plurality of materials respectively having a surface smoothness may be laminated.

Further, as shown in FIG. 11, a regeneration section 284 for regenerating the ion exchanger 256 is provided, and the regeneration of the ion exchanger 256 can be effected during electrolytic processing. The regeneration section 284 comprises a swingable arm 286 having a structure similar to the swingable arm 244 that holds the substrate holder 246 and positioned at the opposite side to the swingable arm 244 across the electrode section 248, and a regeneration head 288 held by the swingable arm 286 at the free end thereof. In operation, the reverse electric potential to that for processing is given to the ion exchanger 256 from the power source 280 (see FIG. 10), thereby promoting dissolution of extraneous matter such as copper adhering to the ion exchanger 256. The regeneration of the ion exchanger 256 during processing can thus be effected. The regenerated ion exchanger 256 is rinsed by pure water or ultrapure water supplied to the upper surface of the electrode section 248.

Next, electrolytic processing by the electrolytic processing apparatus 236 will be described.

First, a substrate W, e.g. a substrate W as shown in FIG. 1B which has in its surface a copper film 6 as a conductor film (portion to be processed), is attracted and held by the substrate holder 246 of the electrolytic processing apparatus 236, and the substrate holder 246 is moved by the swingable arm 244 to a processing position right above the electrode section 248. The substrate holder 246 is then lowered by the actuation of the motor 260 for vertical movement, so that the substrate W held by the substrate holder 246 contacts or gets close to the surface of the ion exchanger 256 mounted on the upper surface of the electrode section 248.

Next, a given voltage is applied from the power source 280 between the processing electrodes 250 and the feeding electrodes 252, while the substrate holder 246 and the electrode section 248 are rotated. At the same time, pure water or ultrapure water is supplied, through the through-hole 248a, from beneath the electrode section 248 to the upper surface thereof, and simultaneously, pure water or ultrapure water is supplied, through the pure water nozzle 274, from above the electrode section 248 to the upper surface thereof, thereby filling pure water or ultrapure water into the space between the processing and feeding electrodes 250, 252 and the substrate W. Thereby, electrolytic processing of the conductor film (copper film 6) formed on the substrate W is effected by hydrogen ions or hydroxide ions produced in the ion exchanger 256.

Thus, pure water or ultrapure water is dissociated through the catalytic reaction in the ion exchanger 256 into OH⁻ ions and H⁺ ions. The OH⁻ ions transfer the electric charge in the vicinity of the processing electrodes 250 and become OH radicals. The OH radicals act on the copper film 6 of the substrate W. Removal (polishing) processing of the copper film 6 is thus effected. The H₂ gas generated at the the feeding electrodes 252 is shut off by the strongly acidic cation-exchange membrane 256c, and is removed to the outside by the flow of pure water or ultrapure pure caused by the centrifugal force due to rotation of the electrode 116, whereby the H₂ gas is prevented from interrupting the removal processing action.

As described above, the fundamental difference between the ion-exchange membrane and the ion-exchange fibers resides in the base material that carries an ion-exchange group. As also described above, the processing rate can be enhanced by allowing pure water or ultrapure water to flow within the ion-exchanger 256.

According to this embodiment, by thus making the ion-exchange 256 a laminate of a multi-layer structure, the total ion-exchange capacity of the ion exchanger (laminate) 256 can be increased, whereby the reaction products (oxides and ions) of the electrolytic reaction can be prevented from accumulating in the ion exchanger 256 in an amount exceeding the accumulation capacity of the laminate. In this regard, if the reaction products are accumulated in the laminate in an amount exceeding the accumulation capacity, the accumulated products may change their forms, and such transformed products can adversely affect the processing rate and its distribution. Further, the provision of the regeneration section 284 makes it possible to regenerate the laminate during processing or in the interval of processings so as to remove the reaction products from the laminate, thereby preventing the reaction products accumulated in the laminate adversely affecting the processing rate and its distribution.

Moreover, the flatness of the processed surface of the workpiece can be enhanced by using, as the ion exchanger 256, one having a high hardness or one having a good surface smoothing, or by using both of them.

At this time, monitors the voltage applied between the processing electrodes 250 and the feeding electrodes 252 or the electric current flowing therebetween to detect the end point (terminal of processing). It is noted in this connection that in electrolytic processing an electric current (applied voltage) varies, depending upon the material to be processed, even with the same voltage (electric current) . Therefore, the end point can surely be detected by the monitoring of changes in electric current or in voltage.

After completion of the electrolytic processing, the power source 280 is disconnected, the rotation of the substrate holder 246 and of the electrode section 248 is stopped. Thereafter, the electrode section 246 is raised, and processed substrate W held by the substrate holder 246 is transferred to next process.

According to this embodiment, pure water, preferably ultrapure water is supplied to the ion exchanger 246. However, as described above, it is also possible to use, instead of pure water or ultrapure water, an electrolysis solution obtained by adding an electrolyte to pure water or ultrapure water, or a liquid obtained by adding a surfactant to pure water or ultrapure water.

Further, the movement of the electrode section 248 and the substrate holder 246 is not limited to the above-described movement. For example, either one of the electrode section and the substrate holder can make an orbital movement (non-rotational movement, also called scroll movement). Any movement may be utilized insofar as it creates a relative movement between the laminate mounted on the electrodes and the substrate.

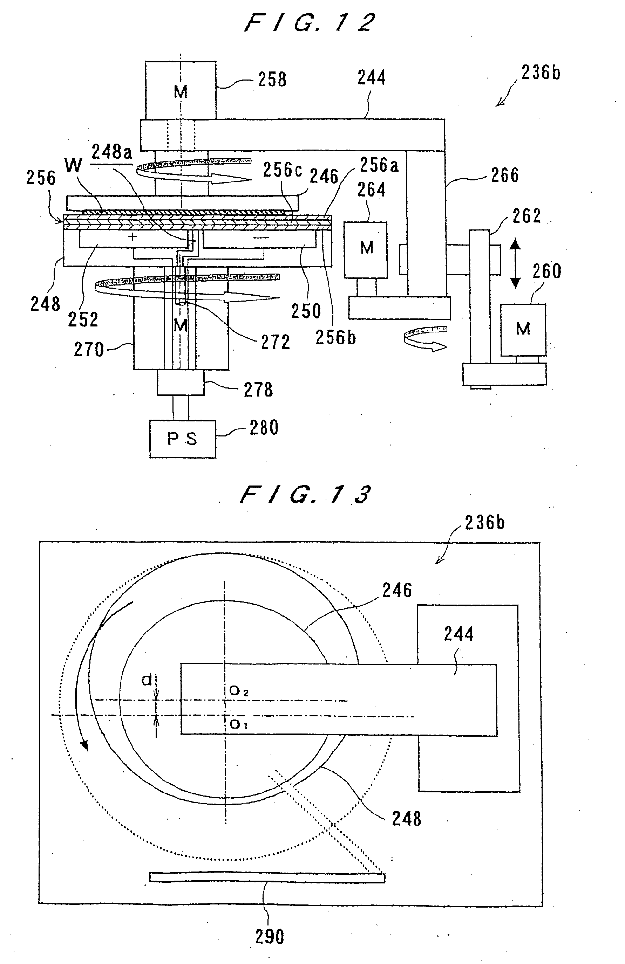

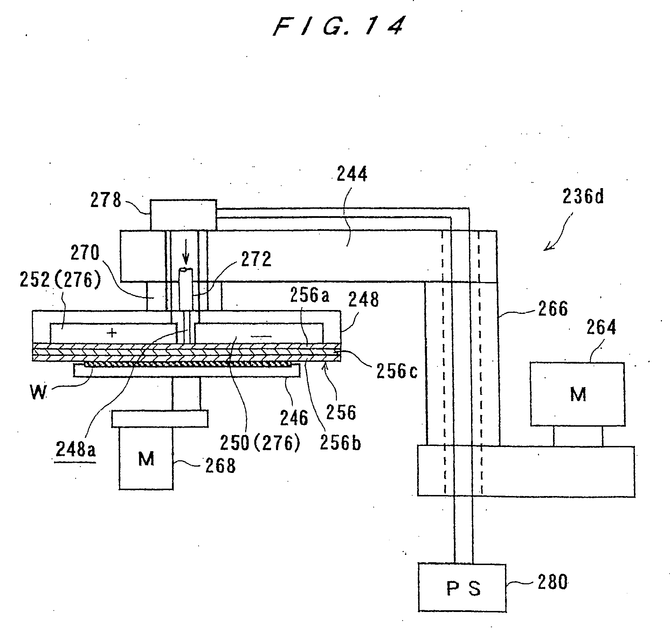

FIGS. 12 and 13 show an electrolytic processing apparatus 236b according to still another embodiment of the present invention. In this electrolytic processing apparatus 236b, the rotational center O₁ of the electrode section 248 is distant from the rotational center O₂ of the substrate holder 246 by a distance d; and the electrode section 248 rotates about the rotational center O₁ and the substrate holder 246 rotates about the rotational center O₂. Further, the processing electrodes 250 and the feeding electrodes 252 are connected to the power source 280 via the slip ring 278.

Further according to this embodiment, the electrode section 248 is designed to have a diameter which is larger than the diameter of the substrate holder 246 to such a degree that when the electrode section 248 rotates about the rotational center O₁ and the substrate holder rotates about the rotational center O₂, the electrode section 248 covers the entire surface of the substrate W held by the substrate holder 246.

According to the electrolytic processing apparatus 236b, electrolytic processing of the surface of the substrate W is carried out by rotating the substrate W via the substrate holder 246 and, at the same, rotating the electrode section 248 by the actuation of the hollow motor 270, while supplying pure water or ultrapure water to the upper surface of the electrode section 248 and applying a given voltage between the processing electrodes 250 and the feeding electrodes 252.

FIGS . 14 and 15 show an electrolytic processing apparatus 236d according to still another embodiment of the present invention. In this electrolytic processing apparatus 236d, the positional relationship between the substrate holder 246 and the electrode section 248 in the preceding embodiments is reversed, and the substrate W is held with its front surface upward (so-called "face-up" manner) so that electrolytic processing is conducted to the upper surface of the substrate. Thus, the substrate holder 246 is disposed beneath the electrode section 248, holds the substrate W with its front surface upward, and rotates about its own axis by the actuation of the motor 268 for rotation. On the other hand, the electrode section 248, which has the processing electrodes 250 and the feeding electrodes 252 that are covered with the ion exchanger 256 consisting of laminated layers (lamination), is disposed above the substrate holder 246, is held with its front surface downward by the swingable arm 244 at the free end thereof, and rotates about its own axis by the actuation of the hollow motor 270. Further, wires extending from the power source 280 pass through a hollow portion formed in the shaft 266 for swinging and reach the slip ring 278, and further pass through the hollow portion of the hollow motor 270 and reach the processing electrodes 250 and the feeding electrodes 252 to apply a voltage therebetween.

Pure water or ultrapure water is supplied from the pure water supply pipe 272, via the through-hole 248a formed in the central portion of the electrode section 248, to the front surface (upper surface) of the substrate W.

A regeneration section 292 for regenerating the ion exchanger (lamination) 256 mounted on the electrode section 248 is disposed beside the substrate holder 246. The regeneration section 292 includes a regeneration tank 294 filled with e.g. a dilute acid solution. In operation, the electrode section 248 is moved by the swingable arm 244 to a position right above the regeneration tank 294, and is then lowered so that at least the ion exchanger 256 of the electrode section 248 is immersed in the acid solution in the regeneration tank 294. Thereafter, the reverse electric potential to that for processing is given to the electrode plates 276, i.e. by connecting the processing electrodes 250 to the anode of the power source 280 and connecting the feeding electrodes 252 to the cathode of the power source 280, thereby promoting dissolution of extraneous matter such as copper adhering to the ion exchanger 256 to thereby regenerate the ion exchanger 256. The regenerated ion exchanger 256 is rinsed by e.g. ultrapure water.

Further according to this embodiment, the electrode section 248 is designed to have a sufficiently larger diameter than the substrate W held by the substrate holder 248. Electrolytic processing of the surface of the substrate W is conducted by lowering the electrode section 248 so that the ion exchanger 256 contacts or gets close to the substrate W held by the substrate holder 246, then rotating the substrate holder 246 and the electrode section 248 and, at the same time, swinging the swingable arm 244 to move the electrode section 248 along the upper surface of the substrate W, while supplying pure water or ultrapure water to the upper surface of the substrate and applying a given voltage between the processing electrode 250 and the feeding electrode 252.

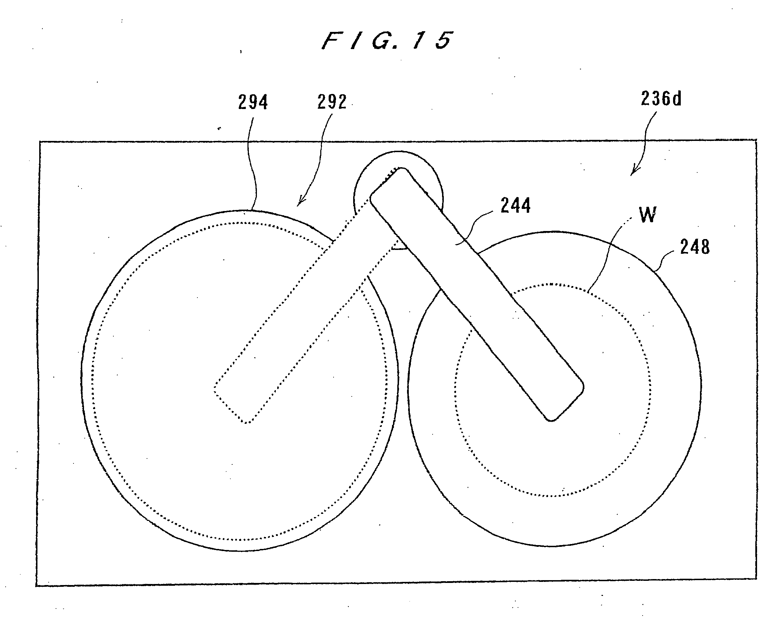

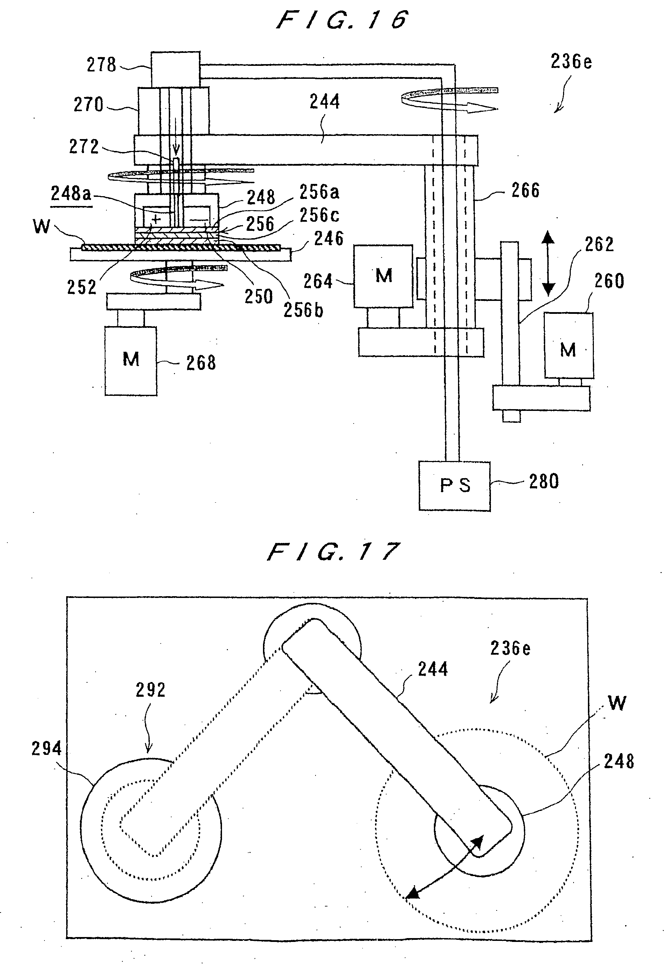

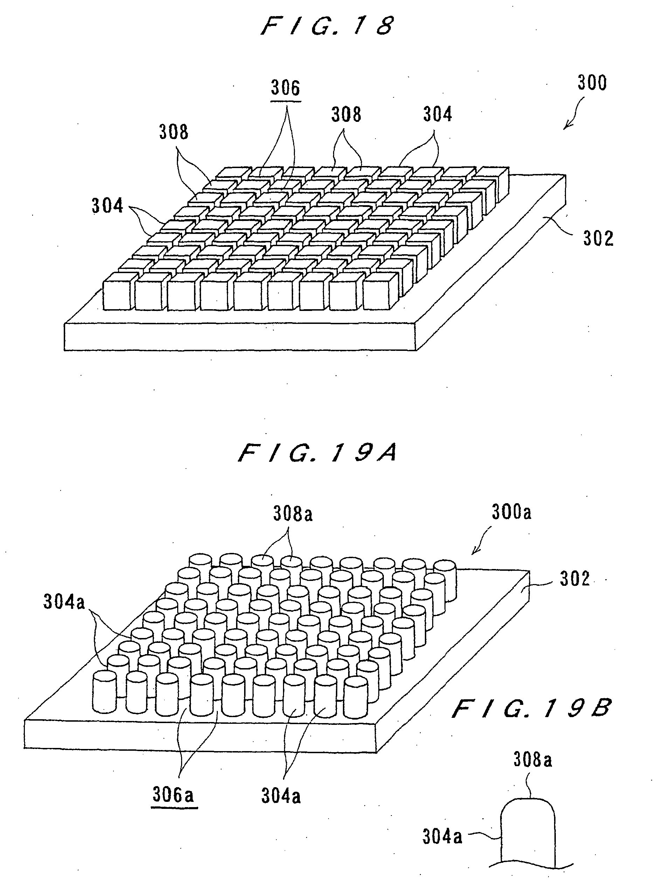

FIGS. 16 and 17 show an electrolytic processing apparatus 236e according to still another embodiment of the present invention. This electrolytic processing apparatus 236e employs, as the electrode section 248, such one that has a sufficiently smaller diameter than that of the substrate W held by the substrate holder 246 so that the surface of the substrate may not be entirely covered with the electrode section 248. The other construction is the same as in the embodiment shown in FIGS. 14 and 15. The above construction can make the electrode section small and compact, and, in addition, can prevent a generated gas from adhering to the substrate.

With respect to the ion exchanger 256 used in the above embodiments, which is the laminate of the ion-exchange materials, the exposed surface of the ion exchanger 256 may be covered with a water-permeable pad (not shown) preferably having a high hardness and a surface smoothness.

By covering the exposed surface of the ion exchanger 256 with an water-permeable pad, direct contact between the exposed surface of the ion exchanger 256 and the to-be-processed material can be avoided, whereby the mechanical life of the ion exchanger 256 can be prolonged. Further, by supplying a slurry from the outside, a CMP processing can be carried out simultaneously.

FIG. 18 shows another ion exchanger 300 usable in the above-described electrolytic processing apparatuses 236, 236b, 236d, 236e. The ion exchanger 300 is composed of a tabular base-side ion exchanger 302 as a base, and a number of surface layer-side ion exchangers 304 in the shape of a quadratic prism, laminated on the surface on the substrate (workpiece) W side of the base-side ion exchanger 302. The surface layer-side ion exchangers 304 are disposed lengthwise and crosswise at given intervals whereby depression portions 306, extending lengthwise and crosswise linearly is a lattice form, are formed in the regions between the circumferential walls of the surface-layer side ion exchangers 304. Further, the surface layer-side ion exchangers 304 form projection portions, and the surfaces of the projection portions constitute, in the surface on the substrate (workpiece) W side of the ion exchanger 300, a plurality of rectangular divided surfaces 308 to face or contact the substrate W. The surface layer-side ion exchangers 304 may be formed e.g. by die molding.

In electrolytic processing, the plurality of rectangular divided surfaces 308 pass an every point in the surface of the substrate W. The depression portions 306 serve as flow passages for allowing a fluid to flow threrthrough.

By thus providing the plurality of divided surfaces 308 in the surface of the ion exchanger 300 and allowing the divided surfaces 308 to pass an every point in the substrate surface, without fragmentation of the electrode itself, the same effect as the fragmentation of the electrode, i.e. equalization (evenness) of the processing rate, can be produced. Further, by providing the depression portions 306 in a lattice form over the entire surface of the ion exchanger 300, a liquid is allowed to flow through the depression portions 306 and spread over the entire surfaces of the ion exchanger 300 and the substrate W.

FIGS. 19A and 19B show still another ion exchanger 300a usable in the above-described electrolytic processing apparatuses 236, 236b, 236d, 236e. The ion exchanger 300a differs from the ion exchanger 300 shown in FIG. 18 in that column-shaped ion surface exchangers 304a are used in the former. The surfaces of the ion exchanger 304a constitute, in the surface on the substrate (workpiece) W side of the ion exchanger 300a, a plurality of circular divided surfaces 308a to face of contact the substrate W. Further, corner-less depression portions 306a are formed by the circumferential walls of the surface layer-side ion exchangers 304a. The other construction is the same as shown in FIG. 18.

With respect to the surface layer-side ion exchangers 304a, as shown in FIG. 19B, the edge of the top surface of each exchanger 304a is preferably rounded off by chamfering for carrying out electrolytic processing smoothly. This holds also for the embodiment shown in FIG. 18 and the below-described embodiments.

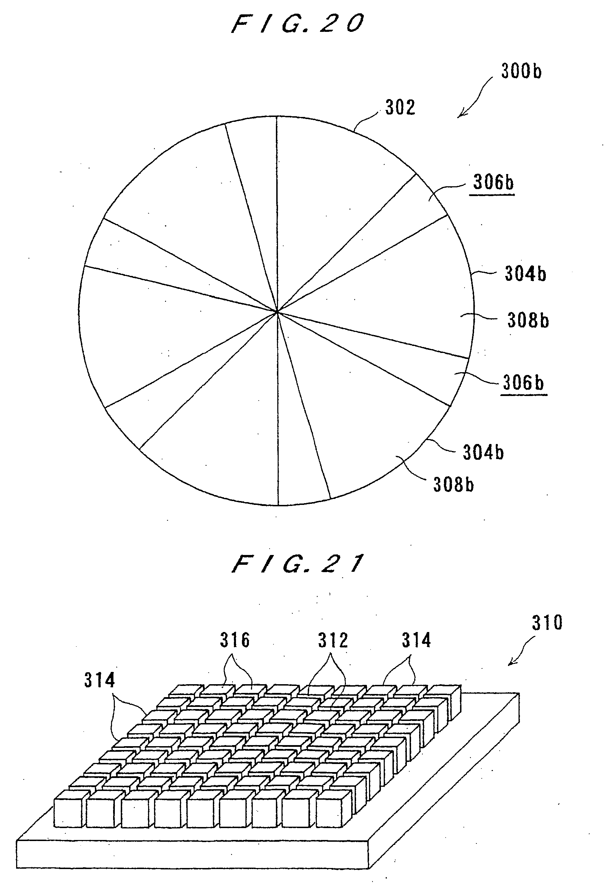

FIG. 20 shows still another ion exchanger 300b usable in the above-described electrolytic processing apparatuses 236, 236b, 236d, 236e. The ion exchanger 300b differs from the ion exchanger 300 shown in FIG. 18 in that the former uses fan-shaped surface layer-side ion exchanger 304b which are disposed radially. The surfaces of the ion exchangers 304b constitute, in the surface on the substrate (workpiece) W side of the ion exchanger 300b, a plurality of fan-shaped divided surfaces 308b to face or contact the substrate W. Further, radially-extending depression portions 306b are formed by the circumferential walls of the surface layer-side ion exchangers 304b. The other construction is the same as shown in FIG. 18.

Though this embodiment employs the surface layer-side ion exchangers 304b of the same fan-shape having the same central angle, it is possible to use different fan-shapes of ion exchangers having different central angles randomly or in any combination.

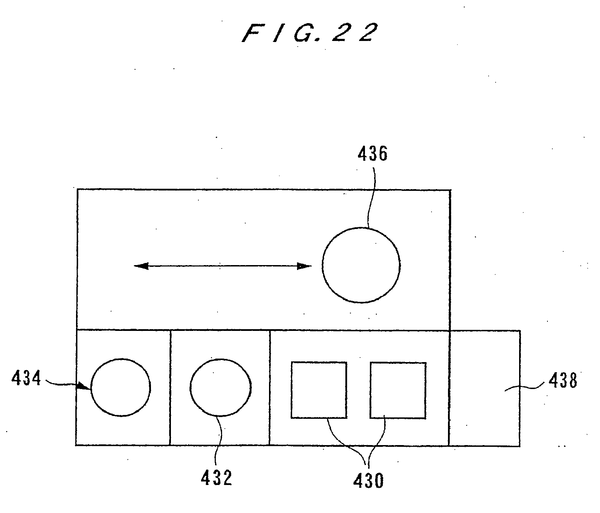

FIG. 21 shows still another ion exchanger 310 usable in the above-described electrolytic processing apparatuses 236, 236b, 236d, 236e. The ion exchanger 310 is of a single-layer structure. Concaves 312 in a lattice form have been formed by grooving in the surface on the substrate (workpiece) W side of the ion exchanger 310. The surfaces of the projection portions 314 surrounded by the depression portions 312 are utilized as the plurality of divided surfaces 316.

It is of course possible to make the ion-exchangers shown in FIGS. 18 to 20 a single-layer structure as in this embodiment.

As described hereinabove, by using a laminate as an ion exchanger to thereby increase the accumulation capacity (ion-exchange capacity), it becomes possible to efficiently process a to-be-processed material, e.g. a conductive material, in the surface of a workpiece, and provide a highly flat processed surface.

FIG. 22 shows another example of a substrate processing apparatus provided with the electrolytic processing apparatus 434 according to still another embodiment of the present invention. As shown in FIG. 22, the substrate processing apparatus comprises a pair of loading/unloading units 430 as a carry-in and carry-out section for carrying in and carrying out a cassette housing a substrate W, e.g. a substrate W as shown in FIG. 1B, which has in its surface a copper film 6 as a conductor film (portion to be processed), a reversing machine 432 for reversing the substrate W, and an electrolytic processing apparatus 434, which are disposed in series. A transfer robot 436 as a transfer device is provided which can move parallel to these apparatuses for transporting and transferring the substrate W therebetween. The substrate processing apparatus is also provided with a monitor 438, for monitoring a voltage applied between a processing electrode and a feeding electrode, adjacent to the loading/unloading units 430.

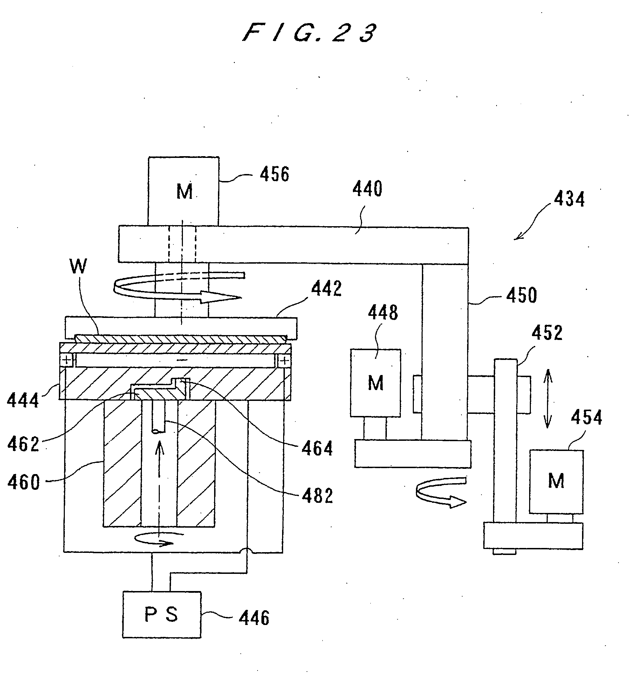

FIG 23 is a vertical sectional view showing the electrolytic processing apparatus 434 in the substrate processing apparatus. As shown in FIG. 23, the electrolytic processing apparatus 434 includes a swingable arm 440 that can swing horizontally and move vertically, a substrate holder 442, supported at the free end of the swingable arm 440, for attracting and holding the substrate W with its front surface downward (face-down), a disc-shaped electrode section 444 positioned beneath the substrate holder 442, and a power source 446 connected to the electrode section 444.

The swingable arm 440, which moves up and down via a ball screw 452 by the actuation of a motor 454 for vertical movement, is connected to the upper end of a shaft 450 that rotates by the actuation of a motor 448 for swinging.

The substrate holder 442 is connected to a substrate-rotating motor 456 as a first drive element that is allowed to move the substrate W held by a substrate holder 442 and the electrode section 444 relatively to each other. The substrate holder 442 is rotated by the actuation of the motor 456. The swingable arm 440 can swing horizontally and move vertically, the substrate holder 442 can swing horizontally and move vertically integrated with the swingable arm 440.

The hollow motor 460 as a second drive element that is allowed to move the substrate W and the electrode section 444 relatively to each other is disposed below the electrode section 444. A drive end 464 is formed at the upper end portion of the main shaft 414 and arranged eccentrically position to the center of the main shaft 424 . The electrode section 444 is connected to the drive end 464 via a bearing (not shown) at the center portion thereof. Three or more of rotation-prevention mechanisms are provided in the circumferential direction between the electrode section 444 and the hollow motor 460.

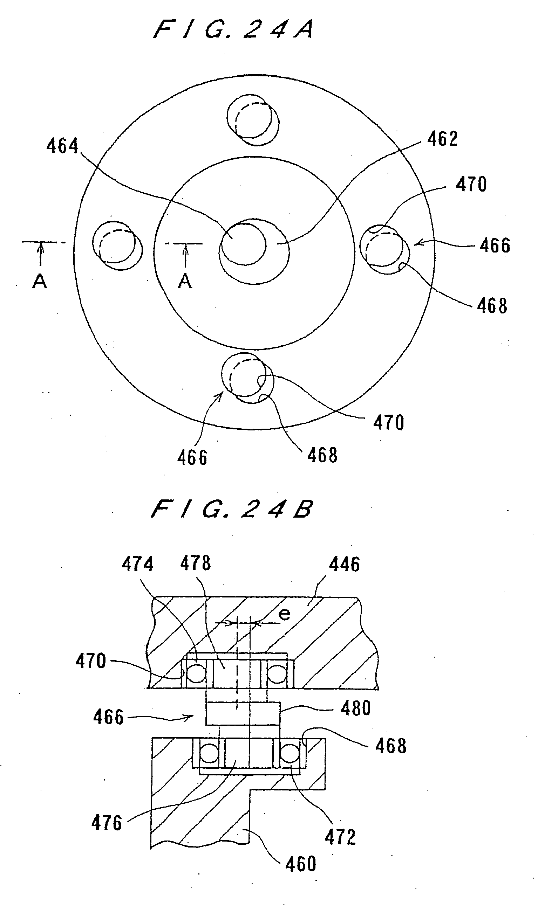

FIG. 24A is a plan view showing the rotation-prevention mechanisms of this embodiment, and FIG. 24B is a cross-sectional view taken along the line A-A of FIG. 24A. As shown in FIGS. 24A and 24B, three or more (four in FIG. 24A) of rotation-prevention mechanisms 400 are provided in the circumferential direction between the electrode section 444 and the hollow motor 460. As shown in FIG. 24B, a plurality of depressions 468, 470 are formed at equal intervals in the circumferential direction at the corresponding positions in the upper surface of the hollow motor 460 and in the lower surface of the electrode section 444. Bearings 472, 474 are fixed in each depression 468, 470, respectively. A connecting member 480, which has two shafts 476, 474 that are eccentric to each other by eccentricity "e", is coupled to each pair of the bearings 472, 474 by inserting the respective ends of the shafts 476, 474 into the bearings 472, 474. Further, a drive end 464, formed at the upper end portion of the main shaft 462 of the hollow motor 460 and arranged eccentrically position to the center of the main shaft 462, is rotatably connected, via a bearing (not shown), to a lower central portion of the electrode section 444. The eccentricity is also "e". Accordingly, the electrode section 444 is allowed to make a translational movement along a circle with radius "e" .

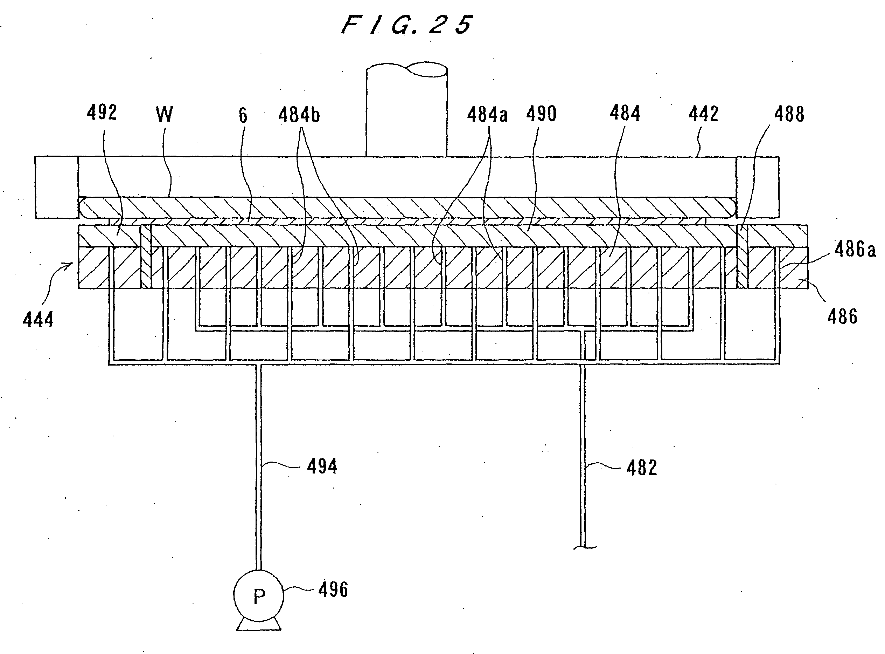

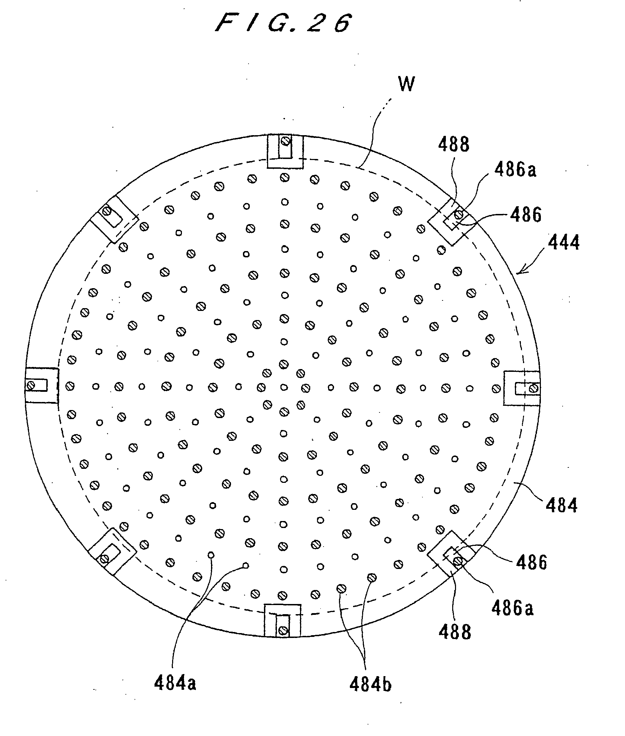

FIG. 25 is a schematic sectional view of the substrate holder 442 and the electrode section 444, and FIG. 26 is a plan view of the electrode section 444. In FIG. 26, the substrate W is shown by a broken line. As shown in FIGS. 25 and 26, the electrode section 444 includes a generally disc-shaped processing electrode 484, a plurality of feeding electrodes 486 disposed in a peripheral portion of the processing electrode 484, and insulators 488 that separate the processing electrode 484 and the feeding electrodes 486. As shown in FIG. 25, the upper surface of the processing electrode 484 is covered with an ion exchanger 490, and the upper surfaces of the feeding electrodes 486 are covered with an ion exchanger 492. The ion exchangers 490 and 492 may be formed integrally. The ion exchangers 490, 492 are not shown in FIG. 23.

According to this embodiment, it is not possible to supply pure water or ultrapure water to the upper surface of the electrode section 444 from above the electrode section 444 during electrolytic processing. Thus, as shown in FIGS. 25 and 26, liquid supply holes 484a, for supplying pure water or ultrapure water to the upper surface of the electrode section 484, are formed in the electrode section 484.

According to this embodiment, a number of fluid supply holes 484a are disposed radially from the center of the processing electrode 484. The fluid supply holes 484a are connected to a fluid supply pipe 482 (see FIG. 25) which extends through the hollow portion of the hollow motor 460, so that pure water or ultrapure water is supplied through the fluid supply holes 484a to the upper surface of the electrode section 444.

Further, a number of fluid section holes 484b are formed in the electrode section 484 for sucking the pure water or ultrapure water supplied through the fluid supply holes 484a to the upper surface of the electrode section 444. The fluid suction holes 484b are disposed radially from the center of the processing electrode 484. Fluid suction holes 486a are formed in the feeding electrodes 486. The fluid suction holes 484b of the processing electrode 484 and the fluid suction holes 486a of the feeding electrode 486 are connected via a fluid suction pipe 494 to a suction device 496 such as a suction pump.

The electrode section 444, in with such a number of fluid supply holes 484a and fluid suction holes 484b, 486a are formed, may be formed by using a porous material, for example a conductive ceramic. The provision of such holes enables the supply and suction of a fluid from the entire surface of the electrode section 444.

In this embodiment, the processing electrode 484 is connected to the cathode of the power source 446, and the feeding electrodes 486 are connected to the anode of the power source 446. According to a to-be-processed material, however, the feeding electrode may be connected to the cathode of the power source 446, and the processing electrode may be connected to the anode.

Next, substrate processing (electrolytic processing) by the substrate processing apparatus of this embodiment will be described. First, a substrate W, e.g. a substrate W as shown in FIG. 1B which has in its surface a copper film 6 as a conductor film (portion to be processed), is taken by the transfer robot 436 out of the cassette housing substrates and set in the loading/unloading unit 430. If necessary, the substrate W is transferred to the reversing machine 432 to reverse the substrate so that the front surface of the substrate W having the conductor film faces downward.

The transfer robot 436 receives the reversed substrate W, and transfers it to the electrolytic processing apparatus 434. The substrate W is then attracted and held by the substrate holder 442. The substrate holder 442, which holds the' substrate W, is moved by the swingable arm 440 to a processing position right above the electrode section 444. The substrate holder 442 is then lowered by the actuation of the motor 454 for vertical movement, so that the substrate W held by the substrate holder 442 contacts or gets close to the surfaces of the ion exchangers 490, 492 of the electrode section 444. Then, the substrate-rotating motor (first drive element) 456 is actuated to rotate the substrate W, at the same time, the hollow motor (second drive element) 460 is actuated to make a scroll movement of the electrode section 444, while supplying pure water or ultrapure water to between the substrate W and ion exchangers 490, 492.

A predetermined voltage is applied from the power source 446 to between the processing electrode 484 and the feeding electrodes 486, and electrolytic processing of the conductor film (copper film 6) in the surface of the substrate W is carried out at the processing electrode (cathode) through the action of hydrogen ions or hydroxide ions produced in the ion exchangers 490, 492. The processing proceeds in the area facing the processing electrode 484, and by the relative movement between the substrate W and the processing electrode 484, the entire surface of the substrate W is processed. During the electrolytic processing, the suction device 496 is driven to suck the pure water or ultrapure water between the substrate W and the ion exchangers 490, 492 through the fluid suction holes 484b of the processing electrode 484 and the fluid suction holes 486a of the feeding electrodes 486.

During the electrolytic processing, processing products and gas bubbles as a by-product are generated in the surfaces of the electrodes 484, 486 and the surface of the substrate W. The reaction products and gas bubbles, present between the electrodes 484, 486 and the substrate W, interfere with migration of ions, and thus interfere with equalization and uniformity of the processing amount of the substrate surface. Especially, the gas bubbles present between the electrodes 484, 486 and the substrate W can cause formation of a pit (small hole, see FIG. 4A) in the surface of the substrate W. It is therefore important to suck, together with pure water, such obstacles as the reaction products and gas bubbles from the surface of the substrate W. According to the present embodiment, as described above, together with pure water or ultrapure water, obstacles as the processing products produced by the electro-chemical reaction between the substrate W and the ions, and the gas bubbles generated by side reactions in the surfaces of the substrate W and the electrodes 484, 486 are sucked through the fluid suction holes 484b of the processing electrode 484 and the fluid suction holes 486a of the' feeding electrodes 486. According to the electrolytic processing apparatus of this embodiment, the obstacles to migration of the ions involved in electrolytic processing can thus quickly removed and discharged from the surface of the substrate W, making it possible to process the surface of the substrate W uniformity and evenly over the entire surface without suffering from the obstacles.

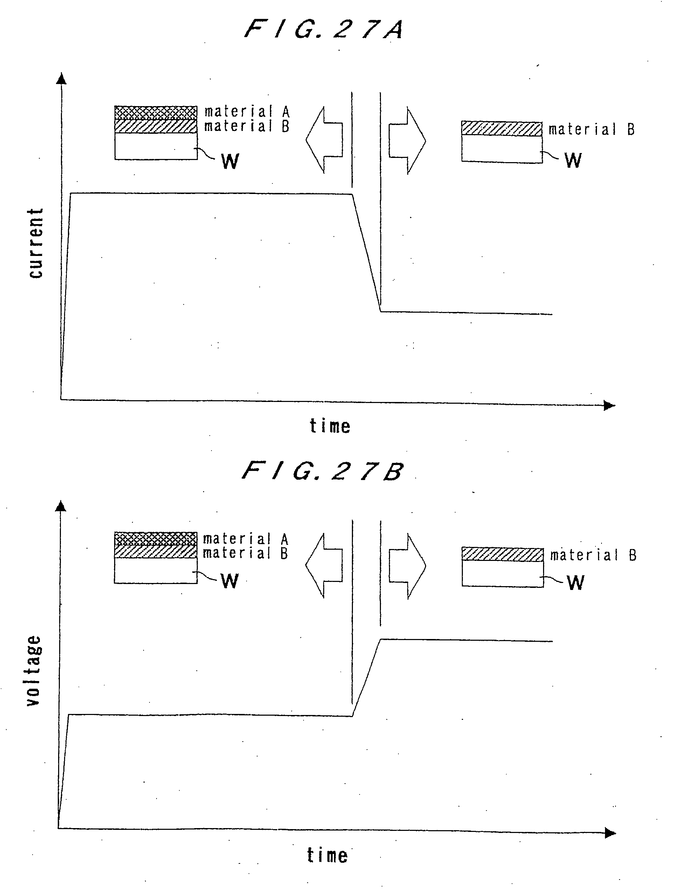

The monitor 438 monitors the voltage applied between the processing electrodes 484 and the feeding electrode 486 or the electric current flowing therebetween to detect the end point (terminal of processing) . It is noted in this connection that in electrolytic processing an electric current (applied voltage) varies, depending upon the material to be processed, even with the same voltage (electric current). For example, as shown in FIG. 27A, when an electric current is monitored in electrolytic processing of the surface of a substrate W to which a film of material B and a film of material A are laminated in this order, a constant electric current is observed during the processing of material A, but it changes upon the shift to the processing of the different material B. Likewise, as shown in FIG. 27B, though a constant voltage is applied between the processing electrode and the feeding electrode during the processing of material A, the voltage applied changes upon the shift to the processing of the different material B. FIG. 27A illustrates, by way of example, a case in which an electric current is harder to flow in electrolytic processing of material B compared to electrolytic processing of material A, and FIG. 27B illustrates a case in which the applied voltage becomes higher in electrolytic processing of material B compared to electrolytic processing of material A. As will be appreciated from the above-described example, the monitoring of changes in electric current or in voltage can surely detect the end point.

Though this embodiment shows the case where the monitor 438 monitors the voltage applied between the processing electrode and the feeding electrode, or the electric current flowing therebetween to detect the end point of processing, it is also possible to allow the monitor 438 to monitor a change in the state of the substrate being processed to detect an arbitrarily set end point of processing. In this case, the end point of processing refers to a point at which a desired processing amount is attained for a specified region in a surface to be processed, or a point at which an amount corresponding to a desired processing amount is attained in terms of a parameter correlated with a processing amount for a specified region in a surface to be processed. By thus arbitrarily setting and detecting the end point of processing even in the middle of processing, it becomes possible to conduct a multi-step electrolytic processing.

For example, the processing amount may be determined by detecting the change of frictional force due to a difference of friction coefficient produced when the processing surface reaches a different material (material B), or the change of frictional force produced by removal of irregularities in the surface of the substrate. The end point of processing may be detected based on the processing amount thus determined. During electrolytic processing, heat is generated by the electric resistance of the to-be-processed surface, or by collision between water molecules and ions which migrate in the liquid (pure water) between the processing surface and the to-be-processed surface. When processing e.g. a copper film deposited on the surface of a substrate under a controlled constant voltage, with the progress of electrolytic processing and a barrier layer and an insulating film becoming exposed, the electric resistance increases and the current value decreases, and the heat value gradually decreases. Accordingly, the processing amount may be determined by detecting the change of the heat value. The end point of processing may therefore be detected. Alternatively, the film thickness of a to-be-processed film on a substrate may be determined by detecting the change in the intensity of reflected light due to a difference of reflectance produced when the processing surface reaches a different material. The end point of processing may be detected based on the film thickness thus determined. The film thickness of a to-be-processed film on a substrate may also be determined by generating an eddy current within a to-be-processed conductive film, e.g. a copper film, and monitoring the eddy current flowing within the substrate to detect change of e.g. the frequency. The end point of processing may thus be detected. Further, in electrolytic processing, the processing rate depends on the value of the electric current flowing between the processing electrode and the feeding electrode, and the processing amount is proportional to the quantity of electricity, determined as the product of the current value and the processing time. Accordingly, the processing amount may be determined by integrating the quantity of electricity, determined as the product of the current value and the processing, and detecting that the integrated value reaches a predetermined value. The end point of processing may thus be detected.

After completion of the electrolytic processing, the power source 446 is disconnected, and the rotation of the substrate holder 442 and the scroll movement of the electrode section 444 are stopped. Thereafter, the substrate holder 444 is raised, and substrate is transferred to the transfer robot 436 after swinging the swingable arm 440. The transfer robot 436 take takes the substrate W from the substrate holder 444 and, if necessary, transfers the substrate to the reversing machine 432 for reversing it, and then returns the substrate W to the cassette in the loading/unloading unit 430.

According to this embodiment, pure water, preferably ultrapure water is supplied to the ion exchangers 490, 492. However, as described above, it is also possible to use, instead of pure water or ultrapure water, an electrolysis solution obtained by adding an electrolyte to pure water or ultrapure water, or a liquid obtained by adding a surfactant to pure water or ultrapure water.

As described above, though the ion exchangers 490, 492 of the electrode section 444 may preferably carry a strongly acidic cation-exchange group (sulfonic acid group), they may also carry a weekly acidic cation-exchange group (carboxyl group), a strongly bas.ic anion-exchange group (quaternary ammonium group) or a weekly basic anion-exchange group (tertiary or lower amino group) .

Though in this embodiment both of the fluid supply holes 484a and the fluid suction holes 484b, 486a are formed in the electrode section 444, it is possible to form only one of fluid supply holes and fluid suction holes in the electrode section 444. Further, according to this embodiment, the fluid supply holes 484a are formed only in the processing electrode 484, and the fluid suction holes 484b, 486a are formed in both of the processing electrode 484 and the feeding electrodes 486. However, fluid supply holes may be formed in both of the processing electrode 484 and the feeding electrodes 486 or only in the feeding electrodes 486, and fluid suction holes may be formed only in the processing electrode 484 or only in the feeding electrode 486.

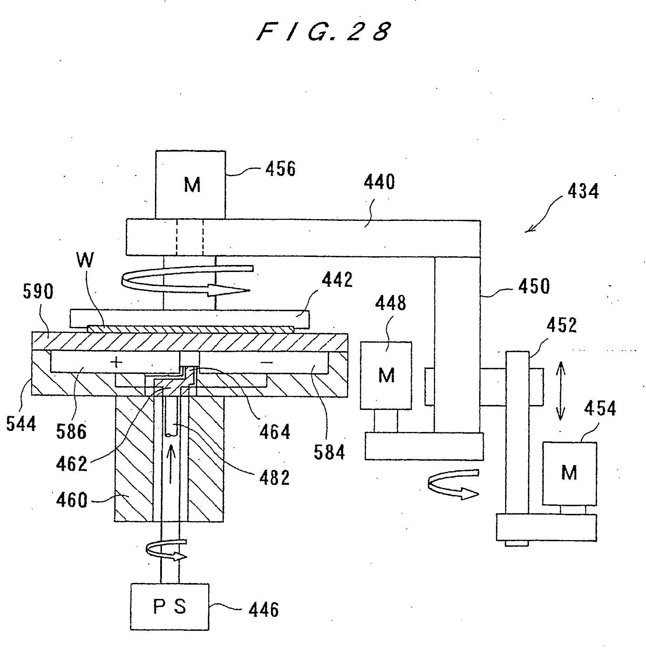

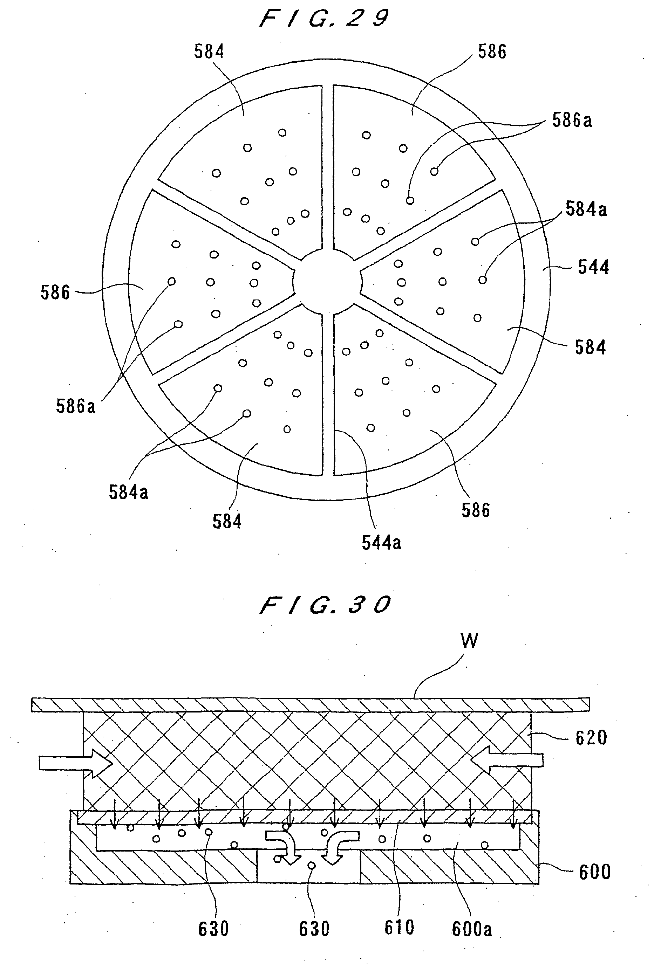

FIG. 28 is a schematic sectional view of an electrolytic processing apparatus according to still another embodiment of the present invention, and FIG. 29 is a plan view of the electrode section of FIG. 27. As shown in FIG. 29, the electrode section 544 of this embodiment includes a processing electrode 584 and a feeding electrode 586, which are divided into pieces separated from one another by ribs 544a composed of an insulator. On the upper surface of the electrode section 544 is mounted an ion exchanger 590 in a membrane form that covers the surfaces of the processing electrode 584 and the feeding electrode 586 entirely. By thus dividing the processing electrode 584 and the feeding electrode 586 respectively and disposing the divided electrodes alternately in the circumferential direction of the electrode section 544, the provision of a fixed feeding section becomes unnecessary, and processing of the entire substrate surface becomes possible.

As shown in FIG. 29, a plurality of fluid supply holes 584a for supplying pure water, preferably ultrapure water are formed in the processing electrode 584. The fluid supply holes 584a are connected to a fluid supply pipe 482 (see FIG. 28) which extends through the hollow portion of a hollow motor 460, whereby pure water or ultrapure water is allowed to be supplied through the fluid supply holes 584a to the upper surface of the electrode section 544. Further, a plurality of fluid suction holes 586a are formed in the feeding electrode 586 for.sucking the pure water or ultrapure water supplied to the upper surface of the electrode section 544. As in the embodiments shown in FIGS. 23 through 26, the fluid suction holes 586a are connected to a suction device (not shown) such as a suction pump. Thus, according to this embodiment, the processing electrode 584 plays the role of fluid supply and the feeding electerode 586 plays the role of fluid suction. The other construction is the same as the above-described embodiments shown in FIGS. 23 through 26.

Though in this embodiment the fluid supply holes 584a are formed in the processing electrode 584 and the fluid suction holes 586a are formed in the feeding electrode 586, it is possible, contrary to that, to form fluid supply holes in the feeding electrode 586 and form fluid suction holes in the processing electrode 584. Further, it is also possible to supply a fluid, not via fluid supply holes formed in the electrode, but from the outside of the electrodes, e.g. by using a nozzle, to between ) the electrodes and the substrate W, and suck the fluid via fluid suction holes formed in the electrode.

Further, it is possible to use a mesh electrode so that the electrode itself can provide fluid suction holes. In this case, as shown in FIG. 30, a mesh electrode 610 is disposed above an electrode holding section 600 having a buffer portion 600a formed therein. The buffer portion 600a is connected to a suction device (not shown) such as a suction pump. The mesh electrode 610 is an electrode in a mesh or network form composed of e.g. platinum, and is excellent in air permeability and water permeability. Since numerous fluid suction holes are formed by the meshes of the mesh electrode 610, the fluid suction efficiency can be increased. Thus, by sucking the fluid, present between the substrate W and the ion exchanger 620, through the meshes of the mesh electrode 610, the above-described obstacles 630 , together with the fluid, can be efficiently sucked and removed. Regarding the mesh size, the use of a too coarse mesh can adversely affect the processing. Accordingly, the coarseness of the mesh is determined in view of the suction efficiency and the processibility. It is also possible to utilize such a mesh electrode to provide itself fluid supply holes.

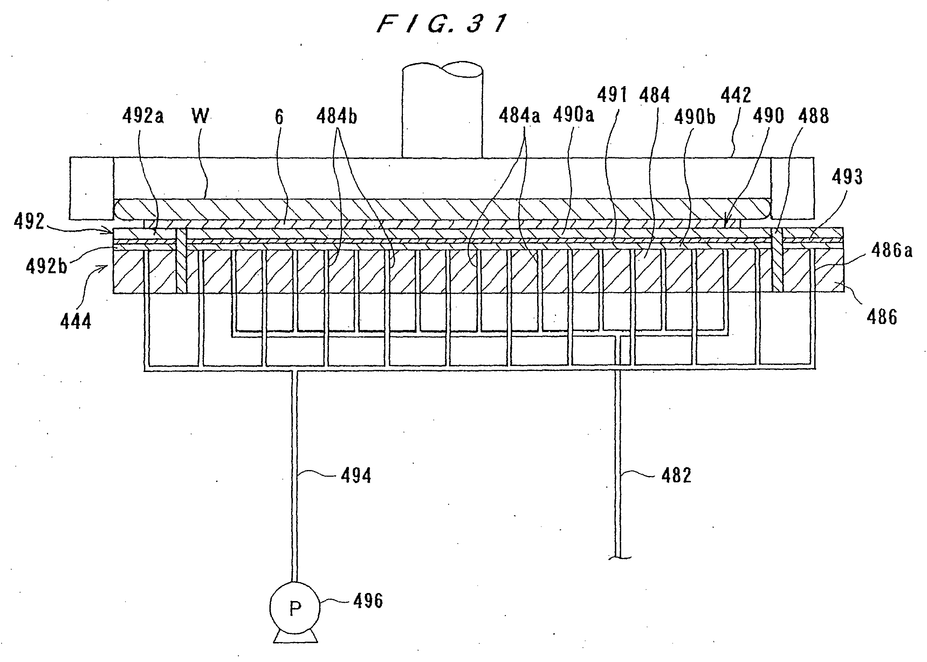

FIG. 31 shows an electrolytic processing apparatus according to still another embodiment of the present invention. In the electrolytic processing apparatus shown in FIG. 31, an electrode section 444 includes a processing electrode 484, a plurality of feeding electrodes 486 disposed in a peripheral portion of the processing electrode 484, and insulators 488 that separate the processing electrode 484 and the feeding electrodes 486. The upper surface of the processing electrode 484 is covered with an ion exchanger 490, and the upper surfaces of the feeding electrodes 486 are covered with an ion exchanger 492. The ion exchangers 490 and 492 may be formed integrally.

A partition 491 is disposed inside the ion exchanger 490 on the upper surface of the processing electrode 484. By the partition 491, the ion exchanger 490 is separated into an upper ion exchanger 490a and a lower ion exchanger 490b. As the partition 491, it is preferable to use an ion-exchange membrane having ion permeability. In the case where the ion exchanger 490 has a cation-exchange ability, it is preferable to use as the partition 491 an ion-exchange membrane having a cation-exchange ability. In the case where the ion exchanger 490 has an anion-exchange ability, it is preferable to use as the partition 491 an ion-exchange membrane having an anion-exchange ability.

Likewise, a partition 493 is disposed inside the ion exchanger 492 on the upper surface of the feeding electrode 486. By the partition 493, the ion exchanger 492 is separated into an upper ion exchanger 492a and a lower ion exchanger 492b. As the partition 493, it is preferable to use an ion-exchange membrane having ion permeability. In the case where the ion exchanger 492 has a cation-exchange ability, it is preferable to use as the partition 493 an ion-exchange membrane having a cation-exchange ability. In the case where the ion exchanger 492 has an anion-exchange ability, it is preferable to use as the partition 493 an ion-exchange membrane having an anion-exchange ability.

According to this embodiment, as shown in FIG. 31, a plurality of fluid supply holes 484a are formed for supplying pure water, preferably ultrapure water to the processing electrode 484. According to this embodiment, a number of fluid supply holes 484a are disposed radially from the center of the processing electrode 484. The fluid supply holes 484a are connected to a fluid supply pipe 482 which extends through the hollow portion of the hollow motor 460, so that pure water or ultrapure water is supplied through the fluid supply holes 484a to the upper surface of the electrode section 444.

Further, a number of fluid suction holes 484b are formed in the electrode section 484 for sucking the pure water or ultrapure water supplied through the fluid supply holes 484a to the upper surface of the electrode section 444. The fluid suction holes 484b are disposed radially from the center of the processing electrode 484. Fluid suction holes 486a are formed in the feeding electrode 486. The fluid suction holes 484b of the processing electrode 484 and the fluid suction holes 486a of the feeding electrode 486 are connected via a fluid suction pipe 494 to a suction device 496 such as a suction pump.

The electrode section 444, in which such a number of fluid supply holes 484a and fluid suction holes 484b, 486a are formed, may be formed by using a porous material, for example a conductive ceramic. The provision of such holes enables the supply and/or suction of a fluid from the entire surface of the electrode section 444. The fluid supply holes 484a and/or the fluid suction holes 484a, 486a may be composed of tubes made from an insulating material.

According to the substrate processing device of this embodiment, as with the above-described electrolytic processing apparatuses shown in FIGS. 23 through 26, the substrate W held by the substrate holder 442 is brought close to or into contact with the surfaces of the ion exchangers 490, 492 of the electrode section 444. Thereafter, the substrate-rotating motor (first drive element) 456 is driven to rotate the substrate Wand, at the same time, the hollow motor 460 (second drive element) 460 is driven to allow the electrode section 444 to make a scroll movement, while pure water or ultrapure water is supplied through the fluid supply holes 484a to between the partition 491 and the processing electrode 484. Part of the pure water or ultrapure water supplied passes through the partition 491 and is fed to the substrate W side.

A predetermined voltage is applied from the power source 446 to between the processing electrode 484 and the feeding electrodes 486, and electrolytic processing of the conductor film (copper film 6) in the surface of the substrate W is carried out at the processing electrode (cathode) through the action of hydrogen ions or hydroxide ions produced in the ion exchangers 490, 492. The processing proceeds in the area facing the processing electrode 484, and by the relative movement between the substrate W and the processing electrode 484, the entire surface of the substrate W is processed. During the electrolytic processing, the suction device 496 is driven to suck the pure water or ultrapure water on the ion exchangers 490, 492 side through the fluid suction holes 484b of the processing electrode 484 and the fluid suction holes 486a of the feeding electrodes 486.

During the electrolytic processing, processing products and gas bubbles as a by-product are generated in the surfaces of the electrodes 484, 486. The reaction products and gas bubbles, present between the electrodes 484, 486 and the substrate, interfere with migration of ions, and thus interfere with equalization of the processing amount of the substrate surface, and can cause formation of a pit (see FIG. 4A) in the surface of the substrate W. It is therefore important to remove, together with pure water, such obstacles as the reaction products and gas bubbles from the surface of the substrate W. According to this embodiment, as described above, since the flow of fluid on the electrodes 484, 486 side is isolated from the flow of fluid on the substrate W side by the partitions 491, 493, the gas bubbles generated in the vicinity of the processing electrode 484 are shut off by the partitions 491, 493 and never reach the surface of the substrate W. The provision of the partitions 491, 493 thus makes it possible to isolate the flow on the side of the processing electrode 484 and the feeding electrodes 486 where the gas-generating reaction takes place from the flow on the to-be-processed surface (substrate W) side, and control the former flow independent of the latter flow. This can prevent the formation of pit in the surface of the substrate W. In this light, it is preferable to use as the partitions 491, 493 ones having lower gas permeability than the ion exchangers 490, 492.

Further according to the present invention, since pure water or ultrapure water is supplied from the fluid supply holes 484a of the processing electrode 484 and the pure water or ultrapure water is sucked from the fluid suction holes 484b of the processing electrode 484 and the fluid suction holes 486a of the feeding electrode 486; the flow of the fluid, which is isolated by the partitions 491, 493 from the flow of fluid on the substrate W side, can be produced on the electrodes 484, 486 side. Accordingly, the air bubbles generated on the side of the processing electrode 484 and the feeding electrodes 486 can be effectively removed by the flow on the electrodes 484, 486 side.

According to the electrolytic processing apparatus of this embodiment, the obstacles to migration of the ions involved in electrolytic processing can thus be quickly removed and discharged from the surface of the substrate W without reaching the substrate surface, making it possible to process the surface of the substrate W evenly over the entire surface without suffering from the obstacles.

It is possible not to provide the ion exchangers 490a, 492a on the upper side of the partitions 491, 493 so that the partitions 491, 493 are allowed to directly contact the surface of the substrate W. Further, the electrolytic processing device of this embodiment is not limited to application to electrolytic processing that uses an ion exchanger and ultrapure water, but can of course be applicable to contact or non-contact electrolytic processing that uses an electrolyte solution.

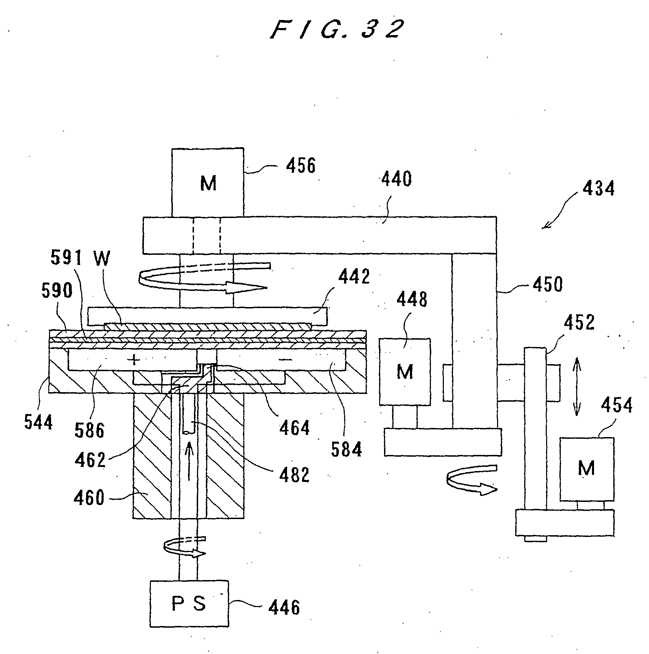

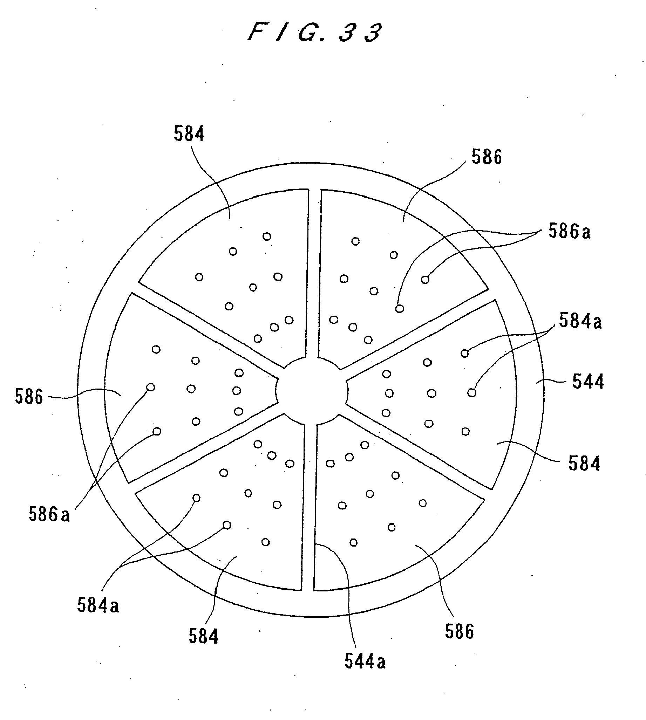

FIG. 32 is a schematic sectional view of an electrolytic processing apparatus according to still another embodiment of the present invention, and FIG. 33 is a plan view of the electrode section of FIG. 32. As shown in FIG. 33, the electrode section 544 of this embodiment includes a processing electrode 584 and a feeding electrode 586, which are divided into pieces separated from one another by ribs 544a composed of an insulator. On the upper surface of the electrode section 544 is mounted an ion exchanger 590 in a membrane form that covers the surfaces of the processing electrode 584 and the feeding electrode 586 entirely. A partition (ion-exchange membrane) 591 is disposed inside the ion exchanger 590 for isolating the flow on the side of the processing electrode 584 and the feeding electrode 586 from the flow on the to-be-processed surface (substrate W) side. By thus dividing the processing electrode 584 and the feeding electrode 586 respectively and disposing the divided electrodes alternately in the circumferential direction of the electrode section 544, the provision of a fixed feeding section becomes unnecessary, and processing of the entire substrate surface becomes possible.

As shown in FIG. 33, a plurality of fluid supply holes 584a for supplying pure water, preferably ultrapure water are formed in the processing electrode 584. The fluid supply holes 584a are connected to a fluid supply pipe 482 (see FIG. 32) which extends through the hollow portion of a hollow motor 460 , whereby pure water or ultrapure water is allowed to be supplied through the fluid supply holes 584a to the upper surface of the electrode section 544. Further, a plurality of fluid suction holes 586a are formed in the feeding electrode 586 for sucking the pure water or ultrapure water supplied to the upper surface of the electrode section 544. As in the embodiment shown in FIG. 31, the fluid suction holes 586a are connected to a suction device (not shown) such as a suction pump. Thus, according to this embodiment, the processing electrode 584 plays the role of fluid supply and the feeding electerode 586 plays the role of fluid suction. The other construction is the same as the above-described embodiment shown in FIG. 31.

Though in this embodiment the fluid supply holes 584a are formed in the processing electrode 584 and the fluid suction holes 586a are formed in the feeding electrode 586, it is possible, contrary to that, to form fluid supply holes in the feeding electrode 586 and form fluid suction holes in the processing electrode 584. Further, it is also possible to supply a fluid, not via fluid supply holes formed in the electrode, but from the outside of the electrodes, e.g. by using a nozzle. Further, though in this embodiment the fluid is first supplied to the electrode side, and the fluid is allowed to pass through the partitions and supplied to the workpiece, it is possible to supply the fluid from the outside directly to the workpiece side e.g. by using a nozzle. Furthermore, though in this embodiment the fluid is discharged by suction through the fluid suction holes formed in the electrode, the fluid may be discharged, not via fluid suction holes, but directly to the outside.

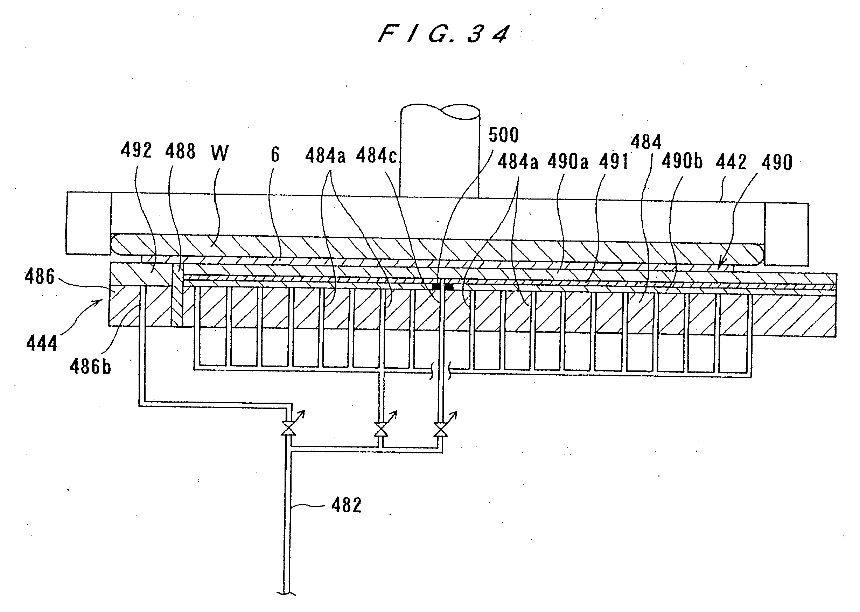

FIG. 34 is a schematic sectional view of a substrate holder and an electrode section in an electrolytic processing device according to still another embodiment of the present invention. According to this embodiment, the partition 491 is disposed only within the ion exchanger 490 on the upper surface of the processing electrode 484, no partition is disposed within the ion exchanger 492 on the upper surface of the feeding electrode 486. Fluid supply holes 484a and 486b for supplying pure water or ultrapure water are formed in the processing electrode 484 and in the feeding electrode 486, respectively, but fluid suction holds as in the embodiments shown in FIGS. 23 through 26 are not formed. Moreover, a fluid supply hole 484c for supplying pure water or ultrapure water directly to the substrate W side is formed in the center of the processing electrode 484. The fluid supply holes 484a, 484c, 486b are connected to the fluid supply pipe 482. The other construction is substantial the same as the embodiments shown in FIGS. 23 through 26.

The fluid supply hole 484c is connected to the ion exchanger 490a on the substrate W side via a separation pipe 500 connected to a hole formed in the center of the partition 491. The function of the separation pipe 500 and the hole formed in the center of the partition 491 is sealed. Accordingly, pure water or ultrapure water supplied from the fluid supply hole 484c passes through the separation pipe 500 and through the partition 491, and is fed directly to the substrate W side. Thus, according to the present invention, the fluid on the processing electrode 484 side, in which gas bubbles etc. are present, is prevented from flowing into the substrate W side.

Though in this embodiment the feeding electrode is provided in the position facing the substrate W, it is possible to feed electricity directly to the substrate, e.g. to a bevel portion (peripheral portion) of the substrate, and make all the electrode facing the substrate a processing electrode. In this case, an electrode for feeding electricity to the bevel portion corresponds to the above-described feeding electrode.

As described hereinabove, according to the embodiments shown in FIGS. 23 through 34, unlike a CMP processing, electrolytic processing of a workpiece, such as a substrate, can be effected through electrochemical action without causing any physical defects in the workpiece that would impair the properties of the workpiece. The electrolytic processing apparatus can effectively remove (clean) matter adhering to the surface of the workpiece such as a substrate. Accordingly, the apparatus can omit a CMP treatment entirely or at least reduce a load upon CMP. Furthermore, the electrolytic processing of a substrate can be effected even by solely using pure water or ultrapure water. This obviates the possibility that impurities such as an electrolyte will adhere to or remain on the surface of the substrate, can simplify a cleaning process after the removal processing, and can remarkably reduce a load upon waste liquid disposal.

The present application is available for PCT/JP02/01545, filed on February 21, 2002, the entire disclosure of which is hereby incorporated by reference.

Although certain preferred embodiments of the present invention have been shown and described in detail, it should be understood that various changes and modifications may be made therein without departing from the scope of the appended claims.

### Industrial Applicability

This invention relates to an electrolytic processing apparatus and method useful for processing a conductive material present in the surface of a substrate, especially a semiconductor wafer, or for removing impurities adhering to the surface of a substrate.

### SUMMARY OF THE INVENTION

1. An electrolytic processing apparatus, comprising:
   a pair of electrodes disposed at a given distance;
   an ion exchanger disposed between the pair of electrodes; and
   a liquid supply section for supplying a liquid to the ion exchanger.
2. The electrolytic processing apparatus according to 1, wherein an exposed surface of the electrode is covered with a water-permeable member.
3. The electrolytic processing apparatus according to 1, wherein said ion exchanger has one or both of an anion-exchange ability and a cation-exchange ability.
4. The electrolytic processing apparatus according to 1, wherein said liquid comprises pure water, liquid having electric conductivity of not more than 500 µS/cm or electrolytic solution.
5. The electrolytic processing apparatus according to 4, wherein said pure water comprises ultrapure water.
6. An electrolytic processing method, comprising:
   providing an electrode section having a pair of electrodes disposed at a given distance with an ion exchanger being interposed; and
   bringing the electrode section into contact with or close to a workpiece while supplying a fluid to the ion exchanger, thereby processing the surface of the workpiece.
7 . The electrolytic processing method according to 6, wherein an exposed surface of the electrode is covered with a water-permeable member.
8. The electrolytic processing method according to 6 , wherein said ion exchanger has one or both of an anion-exchange ability.and a cation-exchange ability.
9. The electrolytic processing method according to 6, wherein said liquid comprises pure water, liquid having electric conductivity of not more than 500 µS/cm or electrolytic solution.
10. The electrolytic processing method according to 9, wherein said pure water comprises ultrapure water.
11. An electrolytic processing apparatus, comprising:
   a processing electrode which can come close to or into contact with a workpiece;
   a feeding electrode for feeding electricity to the workpiece;
   a laminate of a multi-layer structure disposed in at least one of the space between the workpiece and the processing electrode and the space between the workpiece and the feeding electrode;
   a fluid supply section for supplying a fluid to the space between the workpiece and at least one of the processing and feeding electrodes in which the laminate is present; and
   a power source for applying a voltage between the processing electrode and the feeding electrode.
12. The electrolytic processing apparatus according to 11, wherein said laminate includes in at least one layer an ion exchanger having at least one of a cation-exchange group and an anion-exchange group.
13. The electrolytic processing apparatus according to 11, wherein said laminate includes in at least one layer an water-permeable material.
14. The electrolytic processing apparatus according to 11, wherein said laminate has in at least one layer a material having a high hardness.
15. The electrolytic processing apparatus according to 11, wherein said laminate has a material having a high hardness at least in the outermost layer that contacts the workpiece.
16. The electrolytic processing apparatus according to 11, wherein said laminate has a material having a surface smoothness at least in the outermost layer that contacts the workpiece.
17. The electrolytic processing apparatus according to 11, wherein said laminate comprises in at least one layer a material selected from a woven cloth, a net, an ion-exchange membrane, and a polishing pad for chemical mechanical polishing.
18. An electrolytic processing method, comprising:
   bringing a processing electrode into contact with or close to a workpiece while feeding electricity from a feeding electrode to the workpiece;
   disposing a laminate of a multi-layer structure in at least one of the space between the workpiece and the processing electrode and the space between the workpiece and the feeding electrode;
   supplying a fluid to the space between the workpiece and at least one of the processing and feeding electrodes in which the laminate is present; and
   applying a voltage between the processing electrode and the feeding electrode, thereby processing the surface of the workpiece.
19. The electrolytic processing method according to 18, wherein said laminate includes in at least one layer an ion exchanger having at least one of a cation-exchange group and an anion-exchange group.
20. The electrolytic processing method according to 18, wherein said laminate includes in at least one layer a water-permeable material.
21. The electrolytic processing method according to 18, wherein said laminate has in at least one layer a material having a high hardness.
22. The electrolytic processing method according to 18, wherein said laminate has a material having a high hardness at least in the outermost layer that contacts the workpiece.
23. The electrolytic processing method according to 18, wherein said laminate has a material having a surface smoothness at least in the outermost layer that contacts the workpiece.
24. The electrolytic processing method according to 18, wherein said laminate comprises in at least one layer a material selected from a woven cloth, a net, an ion-exchange membrane, and a polishing pad for chemical mechanical polishing.
25. An electrolytic processing apparatus, comprising:
   a processing electrode which can come close to or into contact with a workpiece;
   a feeding electrode for feeding electricity to the workpiece;
   an ion exchanger of a single- or multi-layer structure disposed between the workpiece and the processing electrode or between the workpiece and the feeding electrode, having in the surface on the workpiece side a plurality of divided surfaces that face or contact the workpiece;
   a fluid supply section for feeding a fluid to the space between the workpiece and at least one of the processing and feeding electrodes in which the ion exchanger is present; and
   a power source for applying a voltage between the processing electrode and the feeding electrode.
26. The electrolytic processing apparatus according to 25, wherein said divided surfaces of the ion exchanger are the top surfaces of projection portions in depressions /projections formed in the surface on the workpiece side of the ion exchanger.
27. The electrolytic processing apparatus according to 26, wherein said projections have been formed by die molding.
28. The electrolytic processing apparatus according to 26, wherein said depressions are grooves which have been formed by grooving process in the surface of the ion exchanger.
29. The electrolytic processing apparatus according to 28, wherein said electrolytic processing apparatus has at least one hole for supplying a fluid to or sucking the fluid from the depressions.
30. The electrolytic processing apparatus according to 25, wherein said divided surfaces each have a circular or rectangular form.
31. An electrolytic processing method, comprising:
   bringing a processing electrode into contact with or close to a workpiece while feeding electricity from a feeding electrode to the substrate;
   disposing an ion exchanger of a single- or multi-layer structure between the workpiece and the processing electrode or between the workpiece and the feeding electrode, said ion exchanger having in the surface on the workpiece side a plurality of divided surfaces that face or contact the workpiece;
   supplying a fluid to the space between the workpiece and at least one of the processing and feeding electrodes in which the ion exchanger is present; and
   applying a voltage between the processing electrode and the feeding electrode, thereby processing the surface of the workpiece.
32. An electrolytic processing apparatus, comprising:
   a processing electrode;
   a feeding electrode for supplying electricity to a workpiece;
   a workpiece holder for holding the workpiece and bringing the workpiece into contact with or close to the processing electrode;
   a power source for applying a voltage between the processing electrode and the feeding electrode; and
   a moving mechanism for moving the workpiece held by the workpiece holder and the processing electrode relatively to each other;
   wherein at least one of the processing electrode and the feeding electrode has at least one liquid suction hole defined therein for drawing a liquid present between the workpiece and at least one of the processing electrode and the feeding electrode.
33. The electrolytic processing apparatus according to 32, wherein at least one of said processing electrode and said feeding electrode has at least one liquid supply hole defined therein for supplying said liquid into between the workpiece and at least one of the processing electrode and the feeding electrode.
34. The electrolytic processing apparatus according to 33, wherein said liquid suction hole is defined in one of the processing electrode and the feeding electrode, and the liquid supply hole is defined in the other of the processing electrode and the feeding electrode.
35. The electrolytic processing apparatus according to 32, wherein said electrode having said liquid suction hole comprises a mesh electrode.
36. The electrolytic processing apparatus according to 32, further comprising an ion exchanger disposed in at least one of spaces between the workpiece and the processing electrode and between the workpiece and the feeding electrode.
37. The electrolytic processing apparatus according to 32, wherein said liquid comprises at least one of pure water, ultrapure water, and liquid having an electric conductivity of not more than 500 µS/cm.
38. An electrolytic processing method, comprising:
   disposing a processing electrode and a feeding electrode;
   applying a voltage between the processing electrode and the feeding electrode;
   bringing a workpiece into contact with or close to the processing electrode;
   drawing a liquid present between the workpiece and at least one of the processing electrode and the feeding electrode, through at least one liquid suction hole defined in at least one of the processing electrode and the feeding electrode; and
   processing a surface of the workpiece while the workpiece and the processing electrode are being moved relatively to each other.
39. The electrolytic processing method according to 38, wherein said liquid is supplied into between the workpiece and at least one of the processing electrode and the feeding electrode through at least one liquid supply hole defined in at least one of the processing electrode and the feeding electrode.
40 . The electrolytic processing method according to 39, wherein said liquid suction hole is defined in one of the processing electrode and the feeding electrode, and the liquid supply hole is defined in the other of the processing electrode and the feeding electrode.
41. The electrolytic processing method according to 38, wherein said liquid is supplied into between the workpiece and at least one of the processing electrode and the feeding electrode from the exterior of the processing electrode and the feeding electrode.
42. The electrolytic processing method according to 38, wherein said electrode having said liquid suction hole comprises a mesh electrode.
43. The electrolytic processing method according to 38, further comprising an ion exchanger disposed in at least one of spaces between the workpiece and the processing electrode and between the workpiece and the feeding electrode.
44. The electrolytic processing method according to 38, wherein said liquid comprises at least one of pure water, ultrapure water, and liquid having an electric conductivity of not more than 500 µS/cm.
45. An electrolytic processing apparatus, comprising:
   a processing electrode;
   a feeding electrode for supplying electricity to a workpiece;
   a workpiece holder for holding the workpiece and bringing the workpiece into contact with or close to the processing electrode;
   a power source for applying a voltage between the processing electrode and the feeding electrode;
   a moving mechanism for moving the workpiece held by the workpiece holder and the processing electrode relatively to each other; and
   a partition wall for isolating a liquid flowing on at least one of the processing electrode and the feeding electrode and a liquid flowing on the workpiece from each other.
46. The electrolytic processing apparatus according to 45, further comprising an ion exchanger disposed in at least one of spaces between the workpiece and the processing electrode and between the workpiece and the feeding electrode.
47. The electrolytic processing apparatus according to 46, wherein said partition wall has a small gas permeability.
48. The electrolytic processing apparatus according to 46, wherein said partition wall has an ion permeability.
49. The electrolytic processing apparatus according to 48, wherein said partition wall has an ion-exchange ability.
50. The electrolytic processing apparatus according to 48, wherein said partition wall comprises an ion exchange membrane.
51. The electrolytic processing apparatus according to 48, wherein said partition wall has a cation-exchange ability when said ion exchanger has a cation-exchange ability, and has an anion-exchange ability when said ion exchanger has an anion-exchange ability.
52. The electrolytic processing apparatus according to claim 45, wherein at least one of said processing electrode and said feeding electrode has at least one liquid supply hole defined therein for supplying a liquid into between the workpiece and at least one of the processing electrode and the feeding electrode, or at least one liquid suction hole defined therein for drawing a liquid present between the workpiece and at least one of the processing electrode and the feeding electrode.
53. The electrolytic processing apparatus according to 52, wherein said liquid supplied through said liquid supply hole defined in at least one of the processing electrode and the feeding electrode is passed through the partition wall and supplied onto the workpiece.
54. The electrolytic processing apparatus according to 45, wherein said liquid is supplied onto at least one of the processing electrode and the feeding electrode from the exterior of the processing electrode and the feeding electrode.
55. The electrolytic processing apparatus according to 45, wherein said liquid is supplied onto the workpiece from the exterior of the processing electrode and the feeding electrode.
56. The electrolytic processing apparatus according to 45, wherein said liquid comprises at least one of pure water, ultrapure water, and liquid having an electric conductivity of not more than 500 µS/cm.
57. The electrolytic processing apparatus according to 56, wherein said liquid having an electric conductivity of not more than 500 µS/cm includes a nonionic surfactant
58. An electrolytic processing method, comprising:
   disposing a processing electrode and a feeding electrode;
   applying a voltage between the processing electrode and the feeding electrode;
   bringing a workpiece into contact with or close to the processing electrode;
   isolating a liquid flowing on at least one of the processing electrode and the feeding electrode and a liquid flowing on the workpiece from each other; and
   processing a surface of the workpiece while the workpiece and the processing electrode are being moved relatively to each other.
59. The electrolytic processing method according to 58, further comprising an ion exchanger disposed in at least one of spaces between the workpiece and the processing electrode and between the workpiece and the feeding electrode.
60. The electrolytic processing method according to 59, wherein said partition wall has a small gas permeability.
61. The electrolytic processing method according to 59, wherein said partition wall has an ion permeability.
62. The electrolytic processing method according to 58, wherein said liquid comprises at least one of pure water, ultrapure water, and liquid having an electric conductivity of not more than 500 µS/cm.
63. The electrolytic processing method according to 62, wherein said liquid having an electric conductivity of not more than 500 µS/cm includes a nonionic surfactant.

## Claims

1. An electrolytic processing apparatus, comprising:
a processing electrode;
a feeding electrode for supplying electricity to a workpiece;
a workpiece holder for holding the workpiece and bringing the workpiece into contact with or close to the processing electrode;
a power source for applying a voltage between the processing electrode and the feeding electrode; and
a moving mechanism for moving the workpiece held by the workpiece holder and the processing electrode relatively to each other;
wherein at least one of the processing electrode and the feeding electrode has at least one liquid suction hole defined therein for drawing a liquid present between the workpiece and at least one of the processing electrode and the feeding electrode.

2. The electrolytic processing apparatus according to claim 1, wherein at least one of said processing electrode and said feeding electrode has at least one liquid supply hole defined therein for supplying said liquid into between the workpiece and at least one of the processing electrode and the feeding electrode.

3. The electrolytic processing apparatus according to claim 2 , wherein said liquid suction hole is defined in one of the processing electrode and the feeding electrode, and the liquid supply hole is defined in the other of the processing electrode and the feeding electrode.

4. The electrolytic processing apparatus according to claim 1, wherein said electrode having said liquid suction hole comprises a mesh electrode.

5. The electrolytic processing apparatus according to claim 1 , further comprising an ion exchanger disposed in at least one of spaces between the workpiece and the processing electrode and between the workpiece and the feeding electrode.

6. The electrolytic processing apparatus according to claim 1, wherein said liquid comprises at least one of pure water, ultrapure water, and liquid having an electric conductivity of not more than 500 µS/cm.

7. An electrolytic processing method, comprising:
disposing a processing electrode and a feeding electrode;
applying a voltage between the processing electrode and the feeding electrode;
bringing a workpiece into contact with or close to the processing electrode;
drawing a liquid present between the workpiece and at least one of the processing electrode and the feeding electrode, through at least one liquid suction hole defined in at least one of the processing electrode and the feeding electrode; and
processing a surface of the workpiece while the workpiece and the processing electrode are being moved relatively to each other.

8. The electrolytic processing method according to claim 7, wherein said liquid is supplied into between the workpiece and at least one of the processing electrode and the feeding electrode through at least one liquid supply hole defined in at least one of the processing electrode and the feeding electrode.

9. The electrolytic processing method according to claim 8, wherein said liquid suction hole is defined in one of the processing electrode and the feeding electrode, and the liquid supply hole is defined in the other of the processing electrode and the feeding electrode.

10. The electrolytic processing method according to claim 7 , wherein said liquid is supplied into between the workpiece and at least one of the processing electrode and the feeding electrode from the exterior of the processing electrode and the feeding electrode.

11. The electrolytic processing method according to claim 7 , wherein said electrode having said liquid suction hole comprises a mesh electrode.

12. The electrolytic processing method according to claim 7 further comprising an ion exchanger disposed in at least one of spaces between the workpiece and the processing electrode and between the workpiece and the feeding electrode.

13. The electrolytic processing method according to claim 7 , wherein said liquid comprises at least one of pure water, ultrapure water, and liquid having an electric conductivity of not more than 500 uS/cm.
